# EUROPEAN PATENT APPLICATION

(11) **EP 4 822 678 A1**
(43) Date of publication of application: **14.10.2026**
(21) Application number: 25783104.0
(22) Date of filing: 14.02.2025
(51) Int. Cl.: G09F 19/14, H10H 29/14, H01L 25/075, H10H 20/855, G09G 3/32, G02B 3/10, G02B 3/00

(54) **DISPLAY APPARATUS**

(30) Priority: 05.04.2024 KR 20240046666; 02.08.2024 KR 20240103430
(71) Applicant: Samsung Electronics Co., Ltd., Suwon-si, Gyeonggi-do 16677 (KR)
(72) Inventor: BAEK, Dohyeon, Suwon-si Gyeonggi-do 16677 (KR); NAM, Yujin, Suwon-si Gyeonggi-do 16677 (KR); MIN, Kwansik, Suwon-si Gyeonggi-do 16677 (KR); SOHN, Sanghyun, Suwon-si Gyeonggi-do 16677 (KR); LEE, Keewon, Suwon-si Gyeonggi-do 16677 (KR); JEONG, Seongjoon, Suwon-si Gyeonggi-do 16677 (KR)
(74) Representative: Gulde & Partner
(86) International application number: PCT/KR2025/099357
(87) International publication number: WO 2025/211928

(57) **Abstract**

Provided is a display apparatus including a light source array configured to emit light in a first direction, and a multi-viewpoint lens adjacent to the light source array in the first direction, wherein the light source array includes a first light source configured to emit light to provide an image to a first viewpoint, and a second light source adjacent to the first light source in a second direction different from the first direction, the second light source being configured to emit light to provide an image to a second viewpoint adjacent to the first viewpoint, and wherein the multi-viewpoint lens includes a refractive portion configured to refract light emitted from the first light source to the first viewpoint, and a reflective portion adjacent to the refractive portion in the second direction, the reflective portion being configured to reflect light emitted from the second light source to the second viewpoint.

## Description

### [TECHNICAL FIELD]

Embodiments of the present disclosure relate to a display apparatus.

### [BACKGROUND ART]

A display apparatus is a type of output device that converts acquired or stored electrical information into visual information and displays the converted visual information to a user, and is used in various fields such as homes and businesses.

Display apparatuses include, for example, monitor devices connected to personal computers or server computers, portable computer devices, navigation terminal devices, general television devices, Internet Protocol television (IPTV) devices, portable terminal devices such as smart phones, tablet PCs, personal digital assistants (PDAs), and cellular phones, various display apparatuses used in industrial settings to play back images such as advertisements and movies, or various types of audio/video systems.

Display apparatuses include a type in which the same image is provided to multiple viewpoints facing a screen, and a multi-viewpoint display type in which different images are provided depending on viewpoints.

A multi-viewpoint display apparatus may modulate external light or light emitted from an own light source thereof to provide different images depending on viewpoints. As a method for providing different images depending on viewpoints, there are a holography method and a stereoscopic method.

The holography method is a method of providing different images depending on viewpoints by using an interference phenomenon of coherent light.

The stereoscopic method is a method of providing a plurality of different two-dimensional images separately for each viewpoint.

The stereoscopic method includes an auto-stereoscopic method of separating images from a display apparatus to form a field of view. Types of auto-stereoscopic methods include a parallax barrier method using a parallax barrier, a lenticular lens method, etc.

The lenticular lens method is a method of refracting light incident from a pixel to a lenticular lens and emitting the incident light in a desired direction to provide different images to multiple viewpoints.

### [DISCLOSURE]

### [TECHNICAL PROBLEM]

One or more embodiments provide a display apparatus having an improved structure to provide different images to a plurality of viewpoints.

One or more embodiments provide a display apparatus having an improved structure to expand an area of a plurality of viewpoints.

One or more embodiments provide a display apparatus having an improved structure to reduce image noise and improve image quality.

One or more embodiments provide a display apparatus having an improved structure to prevent a decrease in brightness of an image while expanding an area of a plurality of viewpoints.

Technical tasks to be achieved in this document are not limited to the technical tasks mentioned above, and other technical tasks not mentioned will be clearly understood by those skilled in the art from the description below.

### [TECHNICAL SOLUTION]

According to an aspect of one or more embodiments, there is provided a display apparatus, which is configured to provide a plurality of different images to a plurality of viewpoints, including a light source array configured to emit light in a first direction, and a multi-viewpoint lens adjacent to the light source array in the first direction, wherein the light source array includes a first light source configured to emit light to provide an image to a first viewpoint among the plurality of viewpoints, and a second light source adjacent to the first light source in a second direction different from the first direction, the second light source being configured to emit light to provide an image to a second viewpoint among the plurality of viewpoints adjacent to the first viewpoint in the second direction, and wherein the multi-viewpoint lens includes a refractive portion configured to refract light emitted from the first light source to the first viewpoint, and a reflective portion adjacent to the refractive portion in the second direction, the reflective portion being configured to reflect light emitted from the second light source to the second viewpoint.

The refractive portion may have a lens axis passing through a focus of the refractive portion in the first direction. The reflective portion may include a reflective surface inclined with respect to the first direction such that as a distance from the second light source to the reflective portion increases in the second direction, a distance between the reflective portion and the lens axis decreases.

The reflective portion may have a predetermined refractive index. The reflective portion may include a reflective surface configured to totally reflect light incident from the second light source to the reflective portion.

The reflective portion may further include a refractive surface configured to receive light reflected by the reflective surface. The refractive surface may be configured to refract light reflected by the reflective surface so that an angle of the refracted light inclined with respect to the first direction decreases.

The second light source may include a first edge light source on a first side of the first light source in the second direction, and a second edge light source on a second side of the first light source opposite to the first side of the first light source. The reflective portion may include a first reflective portion on a first side of the refractive portion in the second direction, the first reflective portion configured to reflect light emitted from the first edge light source, and a second reflective portion on a second side of the refractive portion opposite to the first side of the refractive portion, the second reflective portion being configured to reflect light emitted from the second edge light source.

The second viewpoint may include a first edge viewpoint on a first side of the first viewpoint in the second direction, and a second edge viewpoint on a second side of the first viewpoint opposite to the first side of the first viewpoint. The first reflective portion may be configured to reflect light from the first edge light source to the first edge viewpoint. The second reflective portion may be configured to reflect light from the second edge light source to the second edge viewpoint.

The multi-viewpoint lens may be adjacent to a surface of the light source array in the first direction.

The display apparatus may further include an optical sheet between the light source array and the multi-viewpoint lens. The optical sheet is configured to limit a range of light emitted from the first light source and incident on the refractive portion to a first width, and limit a range of light emitted from the second light source and incident on the reflective portion to a second width smaller than the first width.

The optical sheet may include a first hole configured to transmit at least a portion of the light emitted from the first light source and traveling to the refractive portion, and a second adjacent to the first hole in the second direction and configured to transmit at least a portion of the light emitted from the second light source and traveling to the reflective portion. A size of the second hole may be smaller than a size of the first hole.

The first light source may be configured to emit light toward the refractive portion in a range of a first width, and the second light source may be configured to emit light toward the reflective portion in a range of a second width smaller than the first width.

The light source array may include a plurality of light source arrays partitioned from each other. The multi-viewpoint lens may include a plurality of multi-viewpoint lenses corresponding to the plurality of light source arrays, respectively. The refractive portions of each of the plurality of multi-viewpoint lenses may be configured to refract lights such that lights from the first light sources of each of the plurality of light source arrays travel toward the same first viewpoints. The reflective portions of each of the plurality of multi-viewpoint lenses may be configured to reflect lights such that lights from the second light sources of each of the plurality of light source arrays travel toward the same second viewpoints.

The light source array may include a plurality of light source arrays partitioned from each other. The plurality of light source arrays may include a central light source array at a center of the plurality of light source arrays in the second direction, and an outer light source array adjacent to the central light source array in the second direction. The multi-viewpoint lens includes a plurality of multi-viewpoint lenses. The plurality of multi-viewpoint lenses may include a central multi-viewpoint lens adjacent to the central light source array in the first direction, and an outer multi-viewpoint lens adjacent to the outer light source array in the first direction.

The outer multi-viewpoint lens may have an asymmetric shape with respect to a center of the outer multi-viewpoint lens in the second direction.

An angle at which a traveling direction of light emitted from the reflective portion included in the outer multi-viewpoint lens is inclined with respect to the first direction may be greater than an angle at which a traveling direction of light emitted from the reflective portion included in the central multi-viewpoint lens is inclined with respect to the first direction.

The first direction and the second direction may be perpendicular to each other. The multi-viewpoint lens may extend in a third direction different from the first direction and the second direction.

According to another aspect of one or more embodiments, there is provided a display apparatus, which is configured to provide a plurality of different images to a plurality of viewpoints, including a light source array configured to emit light in a first direction, a multi-viewpoint lens adjacent to the light source array in the first direction, and an optical sheet between the light source array and the multi-viewpoint lens, wherein the light source array includes a first light source configured to emit light to provide an image to a first viewpoint among the plurality of viewpoints, and a second light source adjacent to the first light source in a second direction different from the first direction, the second light source being configured to emit light to provide an image to a second viewpoint among the plurality of viewpoints adjacent to the first viewpoint in the second direction, and wherein the multi-viewpoint lens includes a refractive portion configured to refract light emitted from the first light source to the first viewpoint, and a reflective portion adjacent to the refractive portion in the second direction, the reflective portion being configured to reflect light emitted from the second light source to the second viewpoint.

The refractive portion may have a lens axis passing through a focus of the refractive portion in the first direction. The reflective portion may include a reflective surface inclined with respect to the first direction such that as a distance from the second light source to the reflective portion increases in the second direction, a distance between the reflective portion and the lens axis decreases.

The reflective portion may have a predetermined refractive index. The reflective portion may include a reflective surface configured to totally reflect light incident from the second light source to the reflective portion.

The reflective portion may further include a refractive surface configured to receive light reflected by the reflective surface. The refractive surface may be configured to refract light reflected by the reflective surface so that an angle of the refracted light inclined with respect to the first direction decreases.

The optical sheet may be configured to limit a range of light emitted from the first light source and incident on the refractive portion to a first width, and limit a range of light emitted from the second light source and incident on the reflective portion to a second width smaller than the first width.

### [DESCRIPTION OF DRAWINGS]

Embodiments will be more clearly understood from the following detailed description taken in conjunction with the accompanying drawings in which:
FIG. 1 is a perspective view of a display apparatus according to one or more embodiments;
FIG. 2 is a view illustrating that images are provided from a plurality of viewpoints from the display apparatus according to one or more embodiments;
FIG. 3 is an exploded perspective view illustrating components of the display apparatus according to one or more embodiments;
FIG. 4 is a view illustrating a light source array of the display apparatus and light sources included therein according to one or more embodiments;
FIG. 5 is an exploded view illustrating the light source array, multi-viewpoint lenses, and an optical sheet of the display apparatus according one or more embodiments;
FIG. 6 is an enlarged view illustrating the light source array and the multi-viewpoint lens of the display apparatus according to one or more embodiments;
FIG. 7 is an enlarged view illustrating the light source array and the multi-viewpoint lens of the display apparatus according to one or more embodiments;
FIG. 8 is a view illustrating an example in which a multi-viewpoint lens of the display apparatus according to one or more embodiments has a flat reflective surface;
FIG. 9 is a view illustrating an example in which a multi-viewpoint lens of the display apparatus according to one or more embodiments has a coated reflective surface;
FIG. 10 is a view illustrating an example in which a multi-viewpoint lens of the display apparatus according to one or more embodimentshas a reflective portion including a mirror;
FIG. 11 is a view illustrating that light emitted from a plurality of the light sources of the display apparatus according to one or more embodimentspasses through the optical sheet;
FIG. 12 is a view illustrating that light emitted from the plurality of light sources of the display apparatus according to one or more embodiments passes through holes of the optical sheet;
FIG. 13 is a view illustrating that light emitted from the plurality of light sources of the display apparatus according to one or more embodimentspasses through an optical sheet including high refractive index portions and low refractive index portions;
FIG. 14 is a view illustrating that light emitted from the plurality of light sources of the display apparatus according to one or more embodimentspasses through an optical sheet including high refractive index portions and low refractive index portions;
FIG. 15 is a view illustrating that light emitted from the plurality of light sources of the display apparatus according to one or more embodimentspasses through an optical sheet including high refractive index portions and low refractive index portions;
FIG. 16 is a view illustrating that light emitted from the plurality of light sources of the display apparatus according to one or more embodimentsproceeds to the multi-viewpoint lens;
FIG. 17 is a view illustrating a plurality of light source arrays adjacent to each other and a plurality of multi-viewpoint lenses adjacent to each other included in the display apparatus according to one or more embodiments;
FIG. 18 is a view illustrating light source arrays, a central multi-viewpoint lens, and outer multi-viewpoint lenses of the display apparatus according to one or more embodiments;
FIG. 19 is a view illustrating the light source array and the central multi-viewpoint lens of the display apparatus according to one or more embodiments;
FIG. 20 is a view illustrating the light source array and the outer multi-viewpoint lens of the display apparatus according to one or more embodiments;
FIG. 21 is a view illustrating that the light source arrays and the multi-viewpoint lenses of the display apparatus according to one or more embodimentsare spaced apart from each other by a predetermined distance; and
FIG. 22 is a view illustrating the light source array, multi-viewpoint lenses, and a display panel of the display apparatus according to one or more embodiments.

### [MODE FOR INVENTION]

The embodiments described in the present disclosure and the configurations shown in the drawings are only examples of embodiments of the present disclosure, and various modifications may be made at the time of filing of the present disclosure to replace the embodiments and drawings of the present specification.

Like reference numbers or signs in the various drawings of the present disclosure represent parts or components that perform substantially the same functions.

The terms used in this specification are for the purpose of describing the embodiments and are not intended to restrict and/or to limit the present disclosure. For example, the singular expressions herein may include plural expressions, unless the context clearly dictates otherwise. Also, the terms "comprises" and "has" in this specification are intended to indicate that there are features, numbers, steps, operations, components, parts, or combinations thereof described in the specification, and do not exclude the presence or addition of one or more other features, numbers, steps, operations, components, parts, or combinations thereof.

It will be understood that, although terms including ordinal numbers, such as "first," "second," etc., used in this specification may be used to describe various components, these components should not be limited by these terms, and the terms are only used to distinguish one from another component. For example, a first component may be referred to as a second component without departing from the scope of the present disclosure, and similarly, the second component may also be referred to as a first component. The term "and/or" includes any combination of a plurality of related items or any one of a plurality of related items.

The terms "unit," "module," "member," and "block" used in this specification may be implemented as hardware or software, and depending on embodiments, a plurality of "units," "modules," "members," and "blocks" may be implemented as one component, or one "unit," "module," "member," and "block" may include a plurality of components.

Hereinafter, various embodiments of the present disclosure will be described in detail with reference to the accompanying drawings.

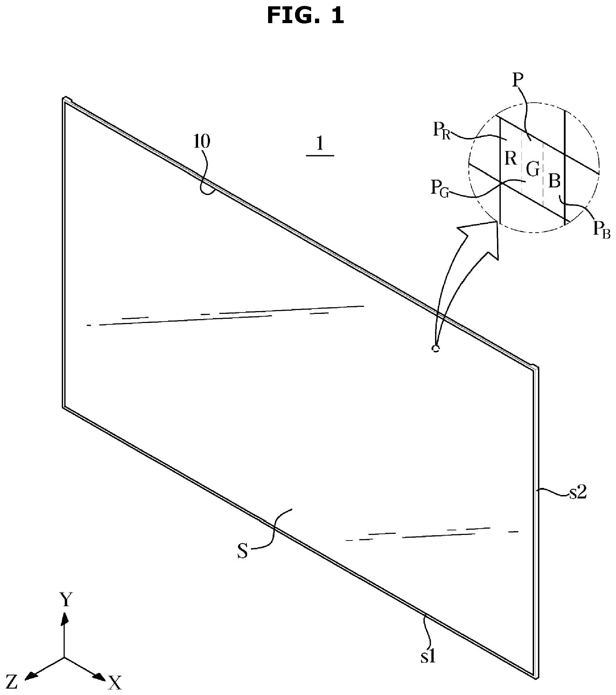

In the description of various embodiments of the present disclosure with reference to FIGS. 1 to 22, the terms "front-rear direction," "vertical direction," "horizontal direction (left-right direction)," and the like used in the following description are defined with respect to the drawings, and the shape and position of each component are not limited by these terms. For example, the term "front-rear direction" may refer to a direction parallel to the Z direction with respect to the drawings. For example, the term " vertical direction" may refer to a direction parallel to the Y direction with respect to the drawings. For example, the term "horizontal direction (left-right direction)" may refer to a direction parallel to the X direction with respect to the drawings.

FIG. 1 is a perspective view of a display apparatus according to one or more embodiments.

Referring to FIG. 1, a display apparatus 1 according to various embodiments of the present disclosure is a device capable of processing an image signal received from the outside and visually displaying the processed image.

For example, the display apparatus 1 according to various embodiments of the present disclosure may be implemented in various forms such as a television (TV), a monitor, which is a type of computer output device, a portable multimedia device, a portable communication device, etc. For example, the display apparatus 1 according to various embodiments of the present disclosure may be a large format display (LFD) installed outdoors, such as on a building rooftop and at a bus stop. Herein, the outdoors is not necessarily limited to outdoors, and the display apparatus 1 according to various embodiments of the present disclosure may be installed in any indoor location where many people may enter and exit, such as, for example, a subway station, a shopping mall, a movie theater, a company, and a store. As long as the display apparatus 1 according to various embodiments of the present disclosure is a device that visually displays an image, the type thereof is not limited to that described above.

For example, the display apparatus 1 may be installed in a standing manner on a floor or furniture indoors or outdoors. For example, the display apparatus 1 may be installed on a wall surface or inside a wall of a building or other structure. For example, the display apparatus 1 may be installed on a wall by a wall mount device.

FIG. 1 illustrates an example in which the display apparatus 1 is a flat display apparatus having a flat screen, but embodiments are not limited thereto, and the display apparatus 1 according to various embodiments of the present disclosure may include a curved display apparatus or a bendable or flexible display apparatus capable of being changed between a flat state and a curved state. The configuration of the present disclosure described below may be applied to display apparatuses of various shapes regardless of a screen size or ratio of the display apparatus.

The display apparatus 1 may receive content including video signals and audio signals from various content sources, and output video and audio corresponding to the video signals and audio signals. For example, the display apparatus 1 may receive content data via a broadcast receiving antenna or a wired cable, receive content data from a content playback device, or receive content data from a content provision server of a content provider.

The display apparatus 1 may display images corresponding to video data and output sounds corresponding to audio data. For example, the display apparatus 1 may restore a plurality of image frames included in the video data and continuously display the plurality of image frames. In addition, the display apparatus 1 may restore audio signals included in the audio data and continuously output sounds according to the audio signals.

The display apparatus 1 may include a screen S configured to display an image. The screen S may be provided on one surface of the display apparatus 1. A side on which the screen S is provided may be defined as a front side of the display apparatus 1. The screen S may be provided on a front surface of the display apparatus 1. The screen S may be configured to display an image in the front. For example, the screen S may display a still image or a moving image. For example, the screen S may display a two-dimensional flat image or a three-dimensional stereoscopic image.

A plurality of pixels P may be formed on the screen S. An image displayed on the screen S may be formed by light emitted from each of the plurality of pixels P. For example, an image may be formed on the screen S by combining light emitted by the plurality of pixels P like a mosaic.

Each of the plurality of pixels P may emit light of various brightness and various colors. For example, each of the plurality of pixels P may include sub-pixels P_{R}, P_{G}, and P_{B}, and the sub-pixels P_{R}, P_{G}, and P_{B} may include the red sub-pixel P_{R} capable of emitting red light, the green sub-pixel P_{G} capable of emitting green light, and the blue sub-pixel P_{B} capable of emitting blue light. For example, red light may represent light with a wavelength from about 620 nm (nanometer, one billionth of a meter) to 750 nm, green light may represent light with a wavelength from about 495 nm to 570 nm, and blue light may represent light with a wavelength from about 450 nm to 495 nm.

Each of the plurality of pixels P may emit light of various brightness and various colors by combining the light emitted from the red sub-pixel P_{R}, the green sub-pixel P_{G}, and the blue sub-pixel P_{B}, respectively.

For example, the screen S of the display apparatus 1 may have a substantially rectangular shape. The screen S may have a first side s1 and a second side s2. The screen S may have a rectangular shape having a pair of the first sides s1 parallel to each other and a pair of the second sides s2 parallel to each other.

For example, the first side s1 of the screen S may be a side parallel to a horizontal direction X, and the second side s2 of the screen S may be a side parallel to a vertical direction Y. For example, the first side s1 of the screen S may be a longer side, and the second side s2 of the screen S may be a shorter side. As illustrated in FIG. 1, the screen S may have a longer side parallel to the horizontal direction X (e.g., the first side s1) and a shorter side parallel to the vertical direction Y (e.g., the second side s2), but is not limited thereto, and the screen S of the display apparatus 1 according to various embodiments of the present disclosure may have a longer side parallel to the vertical direction Y and a shorter side parallel to the horizontal direction X. As another example, the screen S of the display apparatus 1 according to various embodiments of the present disclosure may be provided in a square shape in which lengths of the first side s1 and the second side s2 are substantially the same. As yet another example, the screen S of the display apparatus 1 according to various embodiments of the present disclosure may have various shapes, such as, for example, polygons and circles, in addition to a rectangular shape.

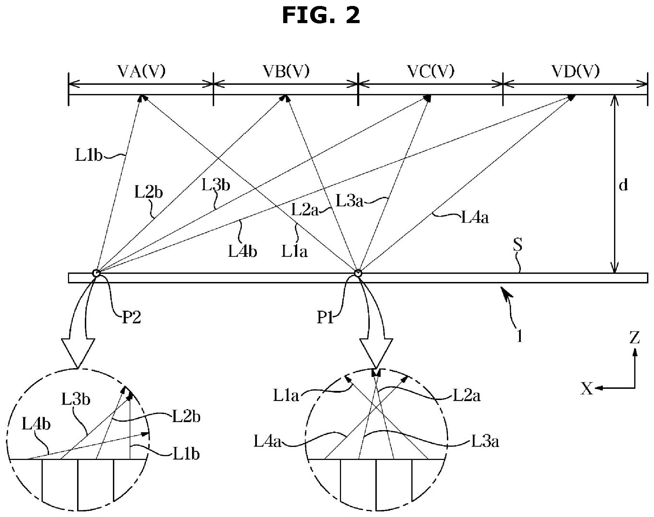

FIG. 2 is a view illustrating that images are provided from a plurality of viewpoints from the display apparatus according to one or more embodiments.

Referring to FIG. 2, the display apparatus 1 according to an embodiment of the present disclosure may be configured to provide different images to viewpoints V facing the screen S. The display apparatus 1 may be configured to display different images depending on viewpoints through the screen S. The display apparatus 1 may use an auto-stereoscopy method of providing different images depending on viewpoints by separating a plurality of different images and displaying the images on the screen S.

The display apparatus 1 may be configured to provide a plurality of different images to a plurality of the viewpoints V. The viewpoint V is formed in an area (hereinafter referred to as 'viewing area') located at a certain distance d from the screen S in a forward direction Z, and may be defined as a point from which a viewer views an image displayed on the screen S. The viewing area may be partitioned into a plurality of viewpoints, and the plurality of viewpoints V may be arranged in one direction along the viewing area.

Hereinafter, the front in which the screen S displays the image is defined as the "first direction Z", and a direction in which the plurality of viewpoints V is arranged is defined as the "second direction X". The first direction Z may be parallel to a direction in which a light source array 20, which will be described later, emits light. The second direction X may be different from the first direction Z. For example, the second direction X may be perpendicular to the first direction Z, but is not limited thereto, and an angle between the first direction Z and the second direction X may not be perpendicular. For example, the second direction X may be parallel to the first side s1 of the screen S. For example, the second direction X may be parallel to the longer side of the screen S. As another example, the second direction X may be parallel to the shorter side of the screen S. For example, the second direction X may be parallel to a horizontal direction of display apparatus 1 parallel to the ground. As another example, the second direction X may be parallel to a vertical direction of the display apparatus 1 perpendicular to the ground.

Hereinafter, a direction different from the first direction Z and the second direction X is defined as the third direction Y. For example, the third direction Y may be perpendicular to the first direction Z and the second direction X, but is not limited thereto, and the third direction Y may not be perpendicular to the first direction Z or the second direction X. Although the drawings illustrate an embodiment in which the third direction Y is parallel to the shorter side of the screen S and parallel to the vertical direction of the display apparatus 1, various embodiments of the present disclosure are not limited thereto.

The properties of the light emitted from the display apparatus 1 may be defined by a light field. The light field may be defined as a function representing a traveling direction and intensity of light at every point in three-dimensional space. The display apparatus 1 may control the light field of light emitted from the screen S so that only a specific image is visible at a specific viewpoint among the plurality of viewpoints V. By allowing only a specific image to be viewed from a specific viewpoint, different images may be provided to the plurality of viewpoints.

For example, referring to FIG. 2, light L1a traveling from a first point P1 on the screen S to a first viewpoint VA, light L2a traveling from the first point P1 to a second viewpoint VB, light L3a traveling from the first point P1 to a third viewpoint VC, and light L4a traveling from the first point P1 to a fourth viewpoint VD may provide different images. A combination of sub-pixels providing the light L1a from the first point P1 on the screen S toward the first viewpoint VA, a combination of sub-pixels providing the light L2a from the first point P1 toward the second viewpoint VB, a combination of sub-pixels providing the light L3a from the first point P1 toward the third viewpoint VC, and a combination of sub-pixels providing the light L4a from the first point P1 toward the fourth viewpoint VD may be different from each other. For example, a viewer may perceive different images when viewing the first point P1 on the screen S from the first viewpoint VA, when viewing the first point P1 on the screen S from the second viewpoint V2, when viewing the first point P1 on the screen S from the third viewpoint V3, and when viewing the first point P1 on the screen S from the fourth viewpoint V4. The first point P1 illustrated in FIG. 2 is exemplified as a point adjacent to a center of the screen S substantially in the second direction X, but is not limited thereto.

Similarly, for example, referring to FIG. 2, light L1b traveling from a second point P2 on the screen S to the first viewpoint VA, light L2b traveling from the second point P2 to the second viewpoint VB, light L3b traveling from the second point P2 to the third viewpoint VC, and light L4b traveling from the second point P2 to the fourth viewpoint VD may provide different images. A combination of sub-pixels providing the light L1b from the second point P2 on the screen S toward the first viewpoint VA, a combination of sub-pixels providing the light L2b from the second point P2 toward the second viewpoint VB, a combination of sub-pixels providing the light L3b from the second point P2 toward the third viewpoint VC, and a combination of sub-pixels providing the light L4b from the second point P2 toward the fourth viewpoint VD may be different from each other. For example, the viewer may perceive different images when viewing the second point P2 on the screen S from the first viewpoint VA, when viewing the second point P2 on the screen S from the second viewpoint V2, when viewing the second point P2 on the screen S from the third viewpoint V3, and when viewing the second point P2 on the screen S from the fourth viewpoint V4. The second point P2 illustrated in FIG. 2 is exemplified as a point adjacent to an edge of the screen S substantially in the second direction X, but is not limited thereto.

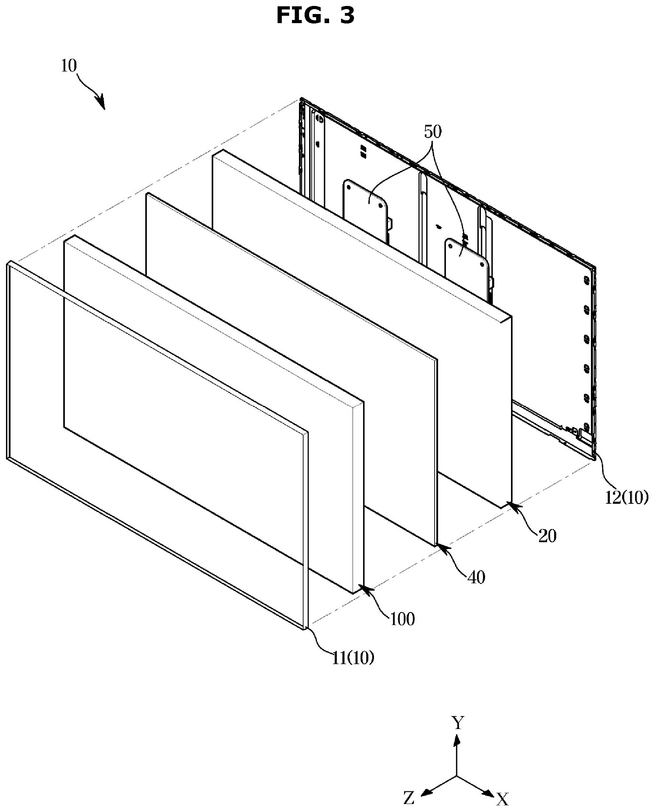

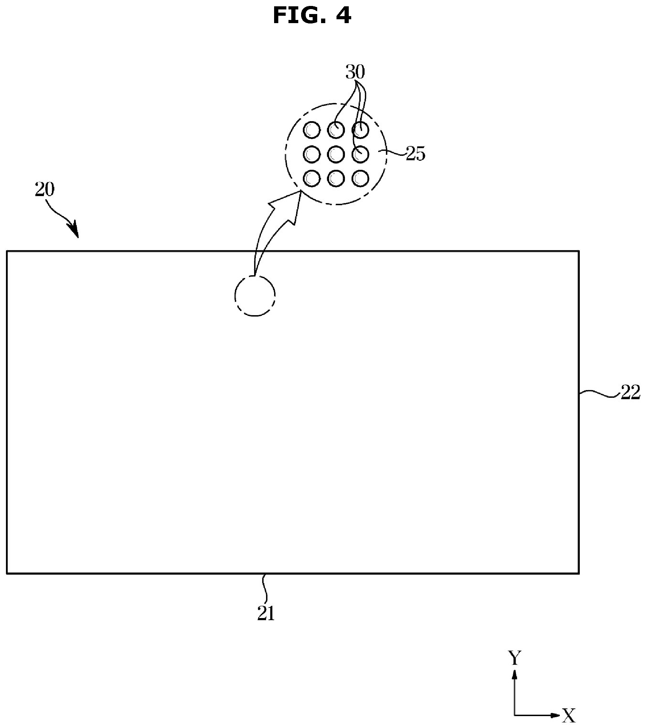

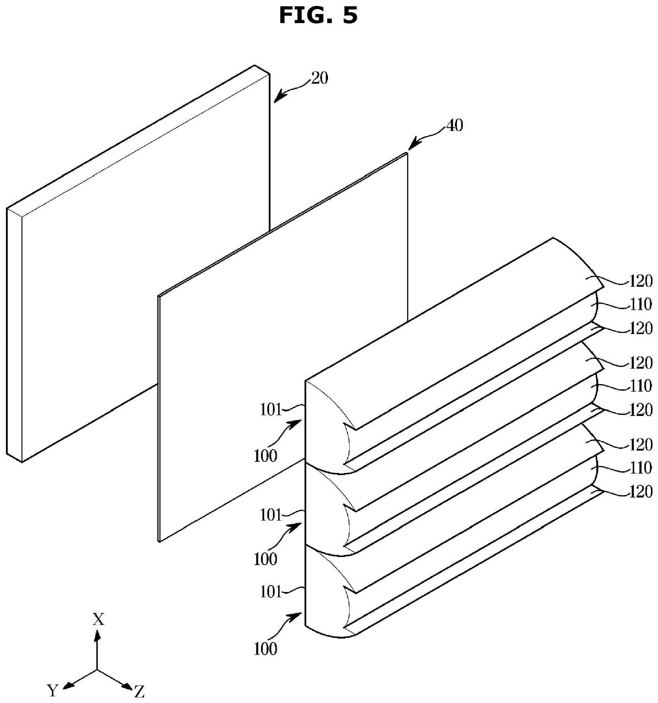

Accordingly, the viewer may perceive as different images being displayed on the screen S depending on the viewpoints V. As described above, in order to provide a plurality of different images to the plurality of viewpoints V, respectively, the display apparatus 1 according to an embodiment of the present disclosure may include a multi-viewpoint lens 100 (see FIGS. 3 and 5, etc.) configured to separate light emitted from a light source 30 (see FIG. 4, etc.) and provide the light to each of the viewpoints V. The multi-viewpoint lens 100 may also be referred to as a "lenticular lens". A detailed explanation of this will be given later.

In the above, it has been explained as an example that the viewing area is partitioned into the four viewpoints VA, VB, VC, and VD, but this is for convenience of explanation and illustration, and in various embodiments of the present disclosure, the viewing area may be partitioned into various numbers of viewpoints.

According to an embodiment of the present disclosure, the display apparatus 1 may be configured to provide images in points spaced apart from each other on the screen S to the plurality of viewpoints V, respectively. For example, the viewpoints VA, VB, VC, and VD at which the lights L1a, L2a, L3a, and L4a from the first point P1 arrive and the viewpoints VA, VB, VC, and VD at which the lights L1b, L2b, L3b, and L4b from the second point P2 arrive may coincide with each other. Accordingly, an area of the plurality of viewpoints V provided by the display apparatus 1 may be expanded, for example, the display apparatus 1 may provide a wider viewing area.

Hereinafter, configurations of the display apparatus 1 for providing different images to the plurality of viewpoints V and providing a wider viewing area will be described in detail with reference to various embodiments of the present disclosure.

FIG. 3 is an exploded perspective view illustrating components of the display apparatus according to one or more embodiments. FIG. 4 is a view illustrating a light source array of the display apparatus and light sources included therein according to one or more embodiments.

Referring to FIGS. 3 and 4, the display apparatus 1 according to an embodiment of the present disclosure may include a case 10 configured to support various components of the display apparatus 1. Various components of the display apparatus 1 may be accommodated in the case 10. The case 10 may form an outer appearance of the display apparatus 1.

For example, the case 10 may support the light source array 20. For example, the case 10 may support the multi-viewpoint lenses 100. For example, the case 10 may support an optical sheet 40. For example, the case 10 may support a board assembly 50.

The case 10 may include a front chassis 11. For example, the front chassis 11 may support a front or side edge of the light source array 20. For example, the front chassis 11 may have the shape of a substantially rectangular frame.

The case 10 may include a rear chassis 12. For example, the rear chassis 12 may cover the rear of the light source array 20. For example, the rear chassis 12 may support the rear of the light source array 20. For example, the rear chassis 12 may support the board assembly 50. For example, the rear chassis 12 may have the shape of a substantially flat plate, but the shape is not limited thereto.

The display apparatus 1 may include the light source array 20 configured to emit light. The light source array 20 may be configured to emit light in the first direction Z. The light source array 20 may be configured to emit light for providing an image.

For example, the light source array 20 may have the shape of a substantially rectangular plate. For example, the light source array 20 may have a shape substantially corresponding to the screen S.

For example, the light source array 20 may have a first side 21 and a second side 22. The light source array 20 may have a pair of the first sides 21 parallel to each other and a pair of the second sides 22 parallel to each other. For example, the first side 21 of the light source array 20 may be parallel to the second direction X. For example, the second side 22 of the light source array 20 may be parallel to the third direction Y. For example, the first side 21 of the light source array 20 may be parallel to a direction in which the plurality of viewpoints V is mutually partitioned and arranged (see FIG. 2).

For example, the first side 21 of the light source array 20 may be parallel to the longer side of the screen S. As another example, the first side 21 of the light source array 20 may be parallel to the shorter side of the screen S. For example, the first side 21 of the light source array 20 may be parallel to the horizontal direction of the display apparatus 1. As another example, the first side 21 of the light source array 20 may be parallel to the vertical direction of the display apparatus 1.

The light source array 20 may include a plurality of the light sources 30. The plurality of light sources 30 may each be configured to emit light in substantially the same direction. The plurality of light sources 30 may each be configured to emit light in the first direction Z. The plurality of light sources 30 may each be configured to emit light in the first direction Z. The light source array 20 may be formed by arranging the plurality of light sources 30 at a regular interval. The interval between the plurality of light sources 30 may be regular or irregular. For example, the light source array 20 may include the plurality of light sources 30 arranged in a plurality of rows and a plurality of columns. The row of the light sources 30 may be an array extending in the second direction X. The column of the light sources 30 may be an array extending in the third direction Y.

For example, the light source 30 may include a light emitting diode element (hereinafter referred to as "LED"). In the light source array 20, a plurality of the LEDs 30 may be arranged in the plurality of rows and the plurality of columns.

A combination of a predetermined number of the light sources 30 arranged adjacent to each other among the plurality of light sources 30 may correspond to each of the pixels P of the screen S. The predetermined number of the light sources 30 arranged adjacent to each other among the plurality of light sources 30 may form each of the pixels P of the screen S, and the plurality of light sources 30 may form an image as a whole.

The light source array 20 may include a light source substrate 25 on which the plurality of light sources 30 is mounted. The light source substrate 25 may include a circuit through which the plurality of light sources 30 is electrically connected. The plurality of light sources 30 may receive driving current through the circuit of the light source substrate 25. For example, the light source substrate 25 may have the shape of a substantially rectangular plate. The light source substrate 25 on which all of the light sources 30 are mounted may be provided as a single body or may be provided as a plurality of the light source substrates 25 separate from each other.

The display apparatus 1 according to an embodiment of the present disclosure may include a self-light emitting type display apparatus in which the light source array 20 using a plurality of LEDs as the light sources 30 may independently display an image. In addition, the light source array 20 of the display apparatus 1 may include various types of display panels, such as a self-light emitting type panel, such as an organic light-emitting diode (OLED) and a micro-LED panel, and a light-receiving/emitting type panel, such as a liquid crystal display (LCD) panel. When the light source array 20 is a light-receiving/emitting display panel such as an LCD panel, each part of pixels formed on the display panel (e.g., sub-pixel) may be defined as the light source 30.

The light source array 20 may be configured to emit light for providing different images to a plurality of viewpoints. A portion of the plurality of light sources 30 may be combined with each other to emit light for providing a specific image (referred to as a first image) to a specific viewpoint (referred to as a first viewpoint) among the plurality of viewpoints V, and another portion of the plurality of light sources 30 may be combined with each other to emit light for providing a specific image (referred to as a second image), which is different from the first image, to a specific viewpoint (referred to as a second viewpoint), which is different from the first viewpoint, among the plurality of viewpoints V.

The number of the plurality of light sources 30 may be equal to or greater than the number of the plurality of viewpoints V included in the entire viewing area. The number of columns of the plurality of light sources 30 may be equal to or greater than the number of the plurality of viewpoints V included in the entire viewing area. The number of light sources 30 included in one row may be equal to or greater than the number of the plurality of viewpoints V included in the entire viewing area.

The display apparatus 1 may include the multi-viewpoint lenses 100 to travel lights emitted from the plurality of light sources 30 toward the respective designated viewpoints V. The multi-viewpoint lens 100 may be disposed in the first direction Z (e.g., front) of the light source array 20. The multi-viewpoint lens 100 may be disposed in the first direction Z of each of the plurality of light sources 30. The multi-viewpoint lens 100 may be configured to travel lights emitted from the plurality of light sources 30 to the respective designated viewpoints V. The multi-viewpoint lens 100 may change paths of lights emitted from the plurality of light sources 30 to emit the lights to the respective designated viewpoints V.

A detailed description of a structure and function of the multi-viewpoint lens 100 will be given later.

The display apparatus 1 may include the optical sheet 40. The optical sheet 40 may be disposed between the light source array 20 and the multi-viewpoint lens 100. The optical sheet 40 may be disposed in the first direction Z of the light source array 20. The optical sheet 40 may be configured to control characteristics of light emitted from the light source array 20. For example, the optical sheet 40 may be configured to limit an angular range of light traveling from the light source array 20 toward the multi-viewpoint lens 100.

A detailed description of a structure and function of the optical sheet 40 will be given later.

The display apparatus 1 may include the various board assemblies 50. Electronic components may be mounted on the board assembly 50, and a circuit including the electronic components may be provided on the board assembly 50. For example, the circuit of the board assembly 50 may be formed by printing a conductive material, such as copper (Cu), in a circuit line pattern on an electrically insulating substrate. The board assembly 50 may be configured to control various components for performing functions of the display apparatus 1, such as the light source array 20, and to supply power to the components.

The board assembly 50 may include various circuit boards such as a main board, a power supply board, and a source board.

For example, the main board may control the overall operation of the display apparatus 1. The main board may include a processor and a power management device for driving the display apparatus 1. The main board may include a control circuit for controlling components such as the light source array 20, a communication module, and a content receiver for receiving content data from content sources.

For example, the power supply board may be configured to supply power to various components of the display apparatus 1. The power supply board 60 may include a switched mode power supply (SMPS) board. The power supply board 60 may include a power supply circuit for supplying power to components such as the light source array 20.

For example, the source board may control the light source array 20. The source board may transmit a driving signal to the light source array 20 to control the driving of each of the plurality of light sources 30. The source board may include a control circuit for controlling the light source array 20.

The circuit boards of the board assembly 50, such as the main board, power supply board, and source board, may be arranged independently of each other or merged with each other. When the circuit boards are arranged independently of each other, the circuit boards may be electrically connected to each other to transmit and receive data, signals, or power. For example, the circuit boards of the board assembly 50 may be electrically connected to each other by cables to perform a function for driving the display apparatus 1. The cables may include various types of cables, such as a film cable, flexible flat cable (FFC), and flexible printed circuit board (FPCB).

The display apparatus 1 may include a cable provided to transmit image data from the board assembly 50 to the light source array 20, a display driver integrated circuit (DDI) configured to process digital image data to output an analog image signal, etc.

The configurations of the display apparatus 1 described above with reference to FIGS. 3 and 4 are merely examples of configurations that the display apparatus 1 according to an embodiment of the present disclosure may include, and the present disclosure is not limited thereto. The display apparatus 1 according to various embodiments of the present disclosure may include various configurations for performing various functions of the display apparatus 1.

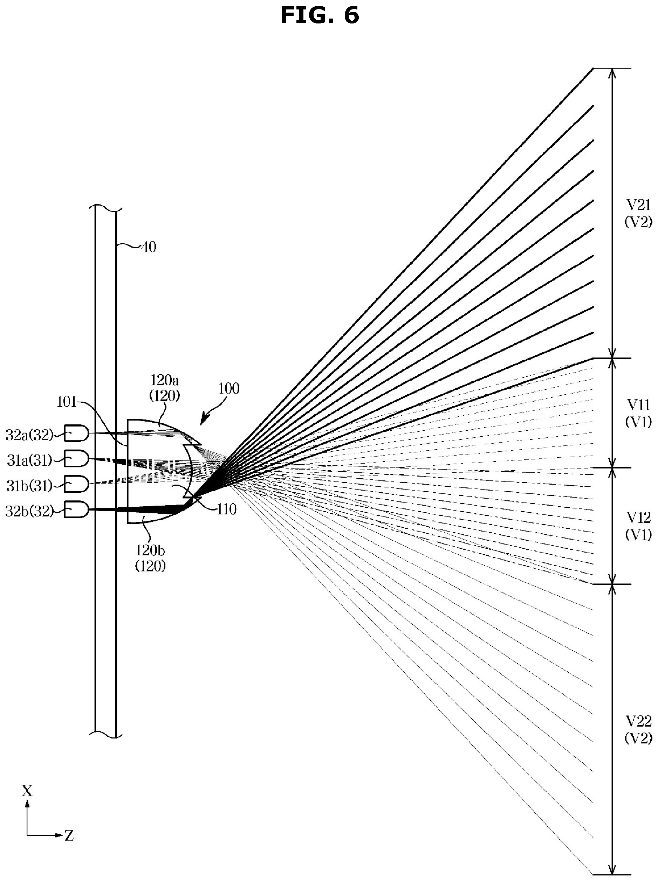

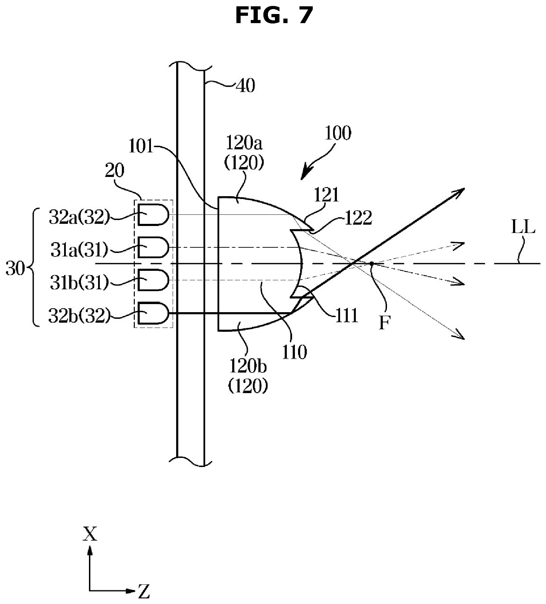

FIG. 5 is an exploded view illustrating the light source array, multi-viewpoint lenses, and an optical sheet of the display apparatus according to one or more embodiments. FIG. 6 is an enlarged view illustrating the light source array and the multi-viewpoint lens of the display apparatus according to one or more embodiments. FIG. 7 is an enlarged view illustrating the light source array and the multi-viewpoint lens of the display apparatus according to one or more embodiments.

Referring to FIGS. 5 to 7, the display apparatus 1 according to an embodiment of the present disclosure may include the light source array 20 including the plurality of light sources 30, and the multi-viewpoint lens 100 configured to change the traveling direction of light emitted from the light source array 20 to emit light to a designated viewpoint among the plurality of viewpoints V.

The multi-viewpoint lens 100 may be disposed in the first direction Z of the light source array 20. As an example, the multi-viewpoint lens 100 may be disposed adjacent to a front surface of the light source array 20. As an example, the multi-viewpoint lens 100 may be attached to the front surface of the light source array 20. As an example, the optical sheet 40 may be provided between the light source array 20 and the multi-viewpoint lens 100, and the multi-viewpoint lens 100 may be attached to a front surface of the optical sheet 40 or disposed in a position adjacent thereto. As an example, an incident surface 101 of the multi-viewpoint lens 100 onto which light from the light source array 20 is incident may be attached to the front surface of the optical sheet 40 or disposed in a position adjacent thereto. In an embodiment in which the optical sheet 40 is not provided between the multi-viewpoint lens 100 and the light source array 20, the incident surface 101 of the multi-viewpoint lens 100 may be attached to the front surface of the light source array 20 or disposed in a position adjacent thereto.

As an example, the multi-viewpoint lens 100 may be fixed to the light source array 20 by adhesive or screws, etc. As an example, the multi-viewpoint lens 100 may be fixed to the optical sheet 40 by adhesive or screws, etc. In addition, the multi-viewpoint lens 100, the optical sheet 40, and the light source array 20 may be fixed to each other in various methods.

As illustrated in FIG. 5, a plurality of the multi-viewpoint lenses 100 may be provided. The plurality of multi-viewpoint lenses 100 may each be disposed in the first direction Z of the light source array 20. The plurality of multi-viewpoint lenses 100 may be arranged with each other in the second direction X. Each of the plurality of multi-viewpoint lenses 100 may be configured to emit light incident from the plurality of light sources 30 to the designated viewpoint V among the plurality of viewpoints V.

Each of the plurality of multi-viewpoint lenses 100 may extend in the third direction Y different from the first direction Z and the second direction X. For example, the third direction Y may be perpendicular to the first direction Z and the second direction X. When the plurality of multi-viewpoint lenses 100 is arranged in the horizontal direction of display apparatus 1, each of the plurality of multi-viewpoint lenses 100 may extend in the vertical direction. When the plurality of multi-viewpoint lenses 100 is arranged in the vertical direction of display apparatus 1, each of the plurality of multi-viewpoint lenses 100 may extend in the horizontal direction. When the plurality of multi-viewpoint lenses 100 is arranged in a longer side direction of the display apparatus 1, each of the plurality of multi-viewpoint lenses 100 may extend in a shorter side direction of the display apparatus 1. When the plurality of multi-viewpoint lenses 100 is arranged in the shorter side direction of the display apparatus 1, each of the plurality of multi-viewpoint lenses 100 may extend in the longer side direction of the display apparatus 1.

As another example, each of the plurality of multi-viewpoint lenses 100 may extend in a direction different from the first direction Z and the second direction X, but the direction may not be a direction perpendicular to the first direction Z and the second direction X. For example, each of the plurality of multi-viewpoint lenses 100 may extend in a direction inclined with respect to a direction perpendicular to the first direction Z and the second direction X. When the plurality of multi-viewpoint lenses 100 is arranged in the horizontal direction of display apparatus 1, each of the plurality of multi-viewpoint lenses 100 may extend in a direction inclined with respect to the vertical direction. When the plurality of multi-viewpoint lenses 100 is arranged in the vertical direction of display apparatus 1, each of the plurality of multi-viewpoint lenses 100 may extend in a direction of being inclined with respect to the horizontal direction. When the plurality of multi-viewpoint lenses 100 is arranged in the longer side direction of the display apparatus 1, each of the plurality of multi-viewpoint lenses 100 may extend in a direction inclined with respect to the shorter direction of the display apparatus 1. When the plurality of multi-viewpoint lenses 100 is arranged in the shorter side direction of the display apparatus 1, each of the plurality of multi-viewpoint lenses 100 may extend in a direction inclined with respect to the longer side direction of the display apparatus 1.

As an example, the plurality of multi-viewpoint lenses 100 may extend in a direction parallel to each other.

Hereinafter, a structure of one of the plurality of multi-viewpoint lenses 100 and the light source array 20 corresponding thereto will be described in detail with reference to FIGS. 6 and 7.

The light source array 20 may include the plurality of light sources 30 arranged in the second direction X. The light source array 20 may include a first light source 31 and a second light source 32 disposed in the second direction X of the first light source 31. The first light source 31 and the second light source 32 may be arranged in the second direction X. The terms "first light source 31" and "second light source 32" described below may each refer to a single light source element (e.g., an LED element), but are not limited thereto, and the "first light source 31" may refer to the one or more first light sources 31, and the "second light source 32" may refer to the one or more second light sources 32. For example, the first light source 31 may include a plurality of the first light sources 31 arranged in the second direction X. For example, the first light source 31 may include the plurality of first light sources 31 arranged in the third direction Y. For example, the second light source 32 may include a plurality of the second light sources 32 arranged in the second direction X. For example, the second light source 32 may include the plurality of second light sources 32 arranged in the third direction Y.

The first light source 31 may be configured to emit light for providing an image to a first viewpoint V1 among the plurality of viewpoints V. For example, a first viewpoint V1 may be located adjacent to a central portion in the plurality of viewpoints V.

The second light source 32 may be configured to emit light for providing an image to the second viewpoint V2 among the plurality of viewpoints V. The second viewpoint V2 may be disposed in the second direction X of the first viewpoint V1. For example, the second viewpoint V2 may be located closer to an edge of the plurality of viewpoints V than the first viewpoint V1. For example, the second viewpoint V2 may be located farther from the center of the plurality of viewpoints V than the first viewpoint V1.

The first viewpoint V1 and the second viewpoint V2 may be partitioned from each other. The first viewpoint V1 and the second viewpoint V2 are partitioned from each other in the viewing area and may be arranged in the second direction X.

The multi-viewpoint lens 100 may be configured to emit light emitted from the first light source 31 to the first viewpoint V1. The multi-viewpoint lens 100 may include a refractive portion 110 configured to emit light emitted from the first light source 31 to the first viewpoint V1.

The refractive portion 110 may be configured to refract light from the first light source 31. The light emitted from the first light source 31 may be incident on the refractive portion 110 through the incident surface 101 of the multi-viewpoint lens 100 and may be refracted while passing through the refractive portion 110. The light passed through the refractive portion 110 may be emitted through an emission surface 111 of the refractive portion 110 and may travel to the first viewpoint V1. For example, the refractive portion 110 may be configured to refract light from the first light source 31 to travel the refracted light to the first viewpoint V1 among the plurality of viewpoints V.

The refractive portion 110 may include various materials having a predetermined refractive index. The refractive portion 110 may also be referred to as the "refractive lens 110".

As an example, the emission surface 111 of the refractive portion 110 may have a curved surface convex in the first direction Z. However, the present disclosure is not limited thereto, and the emission surface 111 may have various shapes of allowing light passed through the refractive portion 110 to be refracted and travel to the first viewpoint V1.

The refractive portion 110 may be disposed in the first direction Z of the first light source 31. The refractive portion 110 may be configured to refract light emitted from the first light source 31 in the first direction Z. In addition to the light emitted from the first light source 31 in the first direction Z, the refractive portion 110 may also refract light emitted in a direction similar to the first direction Z to travel the refracted light to the first viewpoint V1.

The refractive portion 110 may be disposed adjacent to the first light source 31.

As described above, light emitted from the second light source 32 may pass through the multi-viewpoint lens 100 and travel to the second viewpoint V2. According to an embodiment, in a case in which the multi-viewpoint lens 100 is configured such that a path of light emitted from the second light source 32 is changed only through refraction and the light travels, a degree to which the path of light is changed may not be large enough, and there may be a limitation to a distance that the second viewpoint V2 may be spaced apart from a center of the entire viewing area. In this embodiment, the entire viewing area of the display apparatus 1 may not be sufficiently wide. As an amount of light that needs to travel from the center of the viewing area to a viewpoint located further outward increases, the travel path of the light that needs to be changed in angle by the multi-viewpoint lens 100 increases, but in an embodiment that uses only the refraction of light, there may be a limitation on an angle at which the traveling of the light is bent, which may narrow a width of the plurality of viewpoints V or a width of the entire viewing area.

In an example, even in a case in which multiple multi-viewpoint lenses are arranged to provide a plurality of viewpoints, when each of the multi-viewpoint lenses uses only the refraction of light, the display apparatus 1 may not provide a viewing area with a wide width entirely, but rather simply provides a viewing area with a narrow width repeatedly.

In an example, a curvature of the multi-viewpoint lens may be formed to be relatively large (i.e., a radius of curvature may be relatively small) in order to increase an angle of refraction of light by the multi-viewpoint lens, but, in this case, a central thickness of the multi-viewpoint lens increases due to the relatively small radius of curvature, which has the disadvantage that aberrations are expected to increase. In addition, as the radius of curvature of the multi-viewpoint lens decreases, light incident on an area adjacent to an edge of the multi-viewpoint lens may not be able to pass through the multi-viewpoint lens and may be totally reflected back toward the light source 30. In this case, as the light passes through another adjacent multi-viewpoint lens, noise may occur in an image and image quality may be lowered (increased image crosstalk), an amount of light passing the multi-viewpoint lens is reduced, a full width at half maximum (FWHM) of the passed light is limited, and the brightness of the screen S may be reduced.

In order to solve the above problem, according to an embodiment, the multi-viewpoint lens 100 may include a reflective portion 120. The reflective portion 120 may be configured to emit light emitted from the second light source 32 to the second viewpoint V2. The reflective portion 120 may be configured to reflect light emitted from the second light source 32. The reflective portion 120 may be configured to reflect light from the second light source 32 to travel the reflected light to the second viewpoint V2.

The reflective portion 120 may be disposed in the first direction Z of the second light source 32. The reflective portion 120 may be configured to reflect light emitted from the second light source 32 in the first direction Z. In addition to the light emitted from the first light source 31 in the first direction Z, the reflective portion 120 may also reflect light emitted in a direction similar to the first direction Z to travel the reflected light to the second viewpoint V2.

The reflective portion 120 may be configured to reflect light emitted from the second light source 32 to intersect a lens axis LL. For example, the lens axis LL may be an axis passing through a focus F of the refractive portion 110 in the first direction Z. For example, the lens axis LL may be an optical axis of the refractive portion 110. A distance from the multi-viewpoint lens 100 to a point at which light emitted from the reflective portion 120 meets the lens axis LL may be shorter than a distance from the multi-viewpoint lens 100 to the focal point F of the refractive portion 110.

The focus F may be defined as a point at which lights passing through the refractive portion 110 in the first direction Z intersect. For example, as illustrated in FIGS. 6 and 7, the first light source 31 may include a first central light source 31a and a second central light source 31b arranged in the second direction X. Light emitted from the first central light source 31a and light emitted from the second central light source 31b may each be incident the refractive portion 110 through the incident surface 101, and may be refracted while passing through the refractive portion 110 to be emitted through the emission surface 111 of the refractive portion 110. For example, the first viewpoint V1 may include a first central viewpoint V12 and a second central viewpoint V11 arranged in the second direction, and light from the first central light source 31a may be refracted by the refractive portion 110 to travel to the first central viewpoint V12 and light from the second central light source 31b may be refracted by the refractive portion 110 to travel to the second central viewpoint V11. Light emitted from the first central light source 31a in the first direction Z and passed through the refractive portion 110 and light emitted from the second central light source 31b in the first direction Z and passed through the refractive portion 110 may intersect at the focus F.

When light that is emitted from the first light source 31, passes through the refractive portion 110, and travels to the first viewpoint V1 is referred to as first light, and light that is emitted from the second light source 32, reflected by the reflective portion 120, and travels to the second viewpoint V2 is referred to as second light, the first light and the second light may intersect each other. However, the first light at the first viewpoint V1 and the second light at the second viewpoint V2 may not overlap each other, and the first viewpoint V1 and the second viewpoint V2 may be partitioned from each other.

An angle at which a direction in which the second light emitted from the reflective portion 120 travels is inclined with respect to the first direction Z (i.e., a front-rear direction of the light source array 20) may be greater than an angle at which a direction in which the first light emitted from the refractive portion 110 travels is inclined with respect to the first direction Z. For example, an angle at which light incident on the refractive portion 110 in the first direction Z is reflected may be greater than an angle at which light incident on the reflective portion 120 in the first direction Z is refracted.

As such, because the reflective portion 120 uses reflection of light, the reflective portion 120 may change the traveling direction of light to a larger angle compared to a case in which only refraction of light is used. As light from the second light source 32 is bent at a relatively large angle by the reflective portion 120 and travels, the width of the plurality of viewpoints V may increase.

The reflective portion 120 may also be referred to as the "reflector 120".

The reflective portion 120 may include a reflective surface 121 configured to reflect light. The reflective surface 121 may be configured to reflect light from the second light source 32 to the second viewpoint V2. The reflective surface 121 may be inclined with respect to the first direction Z. For example, the reflective surface 121 may be inclined with respect to the first direction Z to become closer to the lens axis LL in the second direction X as a distance away from the second light source 32 increases. For example, the reflective surface 121 may extend to become closer to the lens axis LL in the second direction X as the distance from the incident surface 101 of the multi-viewpoint lens 100 increases. For example, the reflective surface 121 may extend to become closer to the refractive portion 110 in the second direction X as a distance from the second light source 32 increases.

As an example, reflective surface 121 may have a curved surface. As an example, the reflective surface 121 may have a curved surface convex in an outer direction of the multi-viewpoint lens 100. As an example, the reflective surface 121 may have a curved surface whose inclination angle with respect to the first direction Z increases in a second direction X away from the second light source 32.

According to an embodiment, the reflective portion 120 may be configured to have a predetermined refractive index. The reflective portion 120 may include a material with a predetermined refractive index that is filled between the incident surface 101 and the reflective surface 121. Light emitted from the second light source 32 may be incident on the reflective portion 120 through the incident surface 101 of the multi-viewpoint lens 100, and may be totally reflected by the reflective surface 121 while traveling within the reflective portion 120. That is, the reflective surface 121 may be configured to totally reflect light incident from the second light source 32 to the reflective portion 120. Parameters such as the refractive index of the material included in the reflective portion 120 and the inclination angle of the reflective surface 121 may be appropriately set such that light from the second light source 32 is totally reflected to travel toward the second viewpoint V2.

The reflective portion 120 may further include a refractive surface 122. The refractive surface 122 may be located at a position to which light reflected by the reflective surface 121 travels. The refractive surface 122 may be configured to refract light reflected by the reflective surface 121 at a predetermined angle. For example, light emitted from the second light source 32 may be incident on the reflective portion 120 through the incident surface 101 of the multi-viewpoint lens 100, and may be reflected by the reflective surface 121 and then refracted while being emitted through the refractive surface 122. The light emitted from the refractive surface 122 may travel to the second viewpoint V2.

For example, the refractive surface 122 may refract light such that the inclination angle of the traveling direction of the light reflected by the reflective surface 121 with respect to the first direction Z becomes smaller.

A direction in which the refractive surface 122 is disposed may be appropriately set such that light reflected by the reflective surface 121 travels toward the second viewpoint V2.

However, embodiments are not limited thereto, and, for example, a surface through which light reflected by the reflective surface 121 is emitted from the reflective portion 120 toward the second viewpoint V2 may be configured to insubstantially refract light.

The reflective portion 120 may be disposed adjacent to the second light source 32. The reflective portion 120 may be disposed in the first direction Z of the second light source 32.

The reflective portion 120 may be disposed adjacent to the refractive portion 110. The reflective portion 120 may be disposed in the second direction X of the refractive portion 110. The refractive portion 110 and the reflective portion 120 may be arranged in the second direction X.

The reflective portion 120 may be connected to the refractive portion 110. For example, the reflective portion 120 may be formed integrally with the refractive portion 110. For example, the multi-viewpoint lens 100 may be configured as an integrated lens. However, the present disclosure is not limited thereto, and the reflective portion 120 and the refractive portion 110 may be provided as separate configurations.

According to an embodiment, as illustrated in FIGS. 6 and 7, the second light source 32 may include a first edge light source 32a and a second edge light source 32b spaced apart from each other. The first edge light source 32a and the second edge light source 32b may be spaced apart from each other in the second direction X. The first light source 31 may be disposed between the first edge light source 32a and the second edge light source 32b. The first central light source 31a and the second central light source 31b may be disposed between the first edge light source 32a and the second edge light source 32b. The first edge light source 32a may be disposed on one side in the second direction X from the first light source 31. The second edge light source 32b may be disposed on the other side opposite to the first edge light source 32a in the second direction X from the first light source 31. For example, the first edge light source 32a may be disposed on one side in the second direction X from the first central light source 31a, and the second edge light source 32b may be disposed on the other side opposite to the first edge light source 32a and/or the first central light source 31a in the second direction X from the second central light source 31b.

The reflective portion 120 may include a first reflective portion 120a configured to reflect light emitted from the first edge light source 32a. Light emitted from the first edge light source 32a may be incident on the first reflective portion 120a through the incident surface 101 and then reflected by the reflective surface 121 of the first reflective portion 120a. As an example, the light reflected by the reflective surface 121 may be emitted and refracted through the refractive surface 122 of the first reflective portion 120a.

The first reflective portion 120a may be disposed on one side in the second direction X from the refractive portion 110.

The first reflective portion 120a may be disposed in the first direction Z of the first edge light source 32a.

The reflective portion 120 may include a second reflective portion 120b configured to reflect light emitted from the second edge light source 32b. Light emitted from the second edge light source 32b may be incident on the second reflective portion 120b through the incident surface 101 and then reflected by the reflective surface 121 of the second reflective portion 120b. As an example, the light reflected by the reflective surface 121 may be emitted and refracted through the refractive surface 122 of the second reflective portion 120b.

The second reflective portion 120b may be disposed on the other side opposite to the first reflective portion 120a in the second direction X from the refractive portion 110. The refractive portion 110 may be placed between the first reflective portion 120a and the second reflective portion 120b.

The second reflective portion 120b may be disposed in the first direction Z of the second edge light source 32b.

The second viewpoint V2 may include a first edge viewpoint V22 and a second edge viewpoint V21. The first edge viewpoint V22 and the second edge viewpoint V21 may be spaced apart from each other in the second direction X. The first viewpoint V1 may be disposed between the first edge viewpoint V22 and the second edge viewpoint V21. The first central viewpoint V12 and the second central viewpoint V11 may be disposed between the first edge viewpoint V22 and the second edge viewpoint V21. The first edge viewpoint V22 may be disposed in the second direction X from the first viewpoint V1. The second edge viewpoint V21 may be disposed on the other side opposite to the first edge viewpoint V22 in the second direction X from the first viewpoint V1. For example, the first edge viewpoint V22 may be disposed on one side in the second direction X from the first central viewpoint V12, and the second edge viewpoint V21 may be disposed on the other side opposite to the first edge viewpoint V22 and/or the first central viewpoint V12 in the second direction X from the second central viewpoint V11.

The first reflective portion 120a may be configured to reflect light emitted from the first edge light source 32a to the first edge viewpoint V22. The first reflective portion 120a may be configured to reflect light emitted from the first edge light source 32a to intersect the lens axis LL. The light from the first edge light source 32a may have a path changed by the first reflective portion 120a to travel to the first edge viewpoint V22.

The second reflective portion 120b may be configured to reflect light emitted from the second edge light source 32b to the second edge viewpoint V21. The second reflective portion 120b may be configured to reflect light emitted from the second edge light source 32b to intersect the lens axis LL. The light from the second edge light source 32b may have a path changed by the second reflective portion 120b to travel to the second edge viewpoint V21.

The reflective surface 121 of the first reflective portion 120a and the reflective surface 121 of the second reflective portion 120b may each be inclined with respect to the first direction Z. The reflective surface 121 of the first reflective portion 120a and the reflective surface 121 of the second reflective portion 120b may be disposed to become closer to each other in the second direction X as a distance from the light source 30 in the first direction Z increases.

By this configuration, in various embodiments of the present disclosure, the multi-viewpoint lens 100 may emit light from the light source array 20 in a wider range of angle, and the display apparatus 1 may provide a wider viewing area.

Although FIGS. 6 and 7 illustrate an embodiment in which the light source array 20 includes the light source 30 having four of the first central light sources 31a, second central light source 31b, first edge light source 32a, and second edge light source 32b, and the plurality of viewpoints V includes the viewpoint V having four of the first central viewpoint V12, second central viewpoint V11, first edge viewpoint V22 and second edge viewpoint V21 partitioned from each other, in various embodiments, the number of the plurality of viewpoints V and the number of the plurality of light sources 30 are not limited thereto.

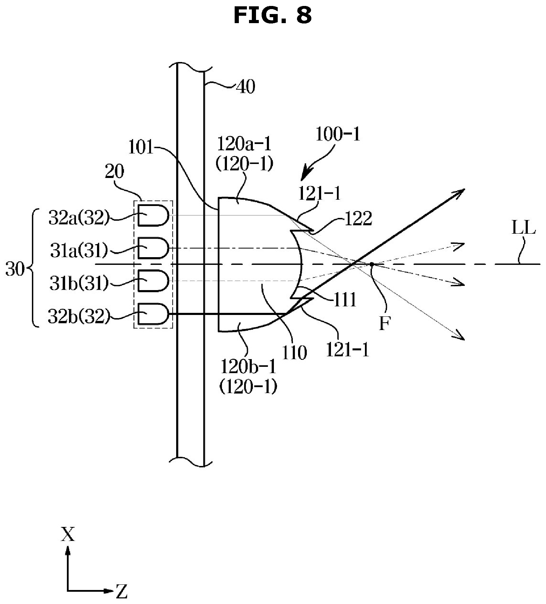

FIG. 8 is a view illustrating an example in which a multi-viewpoint lens of the display apparatus according to one or more embodiments has a flat reflective surface.

Referring to FIG. 8, a multi-viewpoint lens 100-1 of the display apparatus 1 according to an embodiment of the present disclosure may include the refractive portion 110 and a reflective portion 120-1. A detailed description of features of the refractive portion 110 and the reflective portion 120-1 corresponds to the description of the refractive portion 110 and the reflective portion 120 in the above-described embodiment, and thus a repeated description thereof may be omitted.

The reflective portion 120-1 may include a reflective surface 121-1 configured to reflect light from the second light source 32. The reflective surface 121-1 may be configured to reflect light from the second light source 32 to travel the reflected light to the second viewpoint V2. For example, a first reflective portion 120a-1 may include the reflective surface 121-1 configured to reflect light from the first edge light source 32a to travel the reflected light to the first edge viewpoint V22. For example, a second reflective portion 120b-1 may include the reflective surface 121-1 configured to reflect light from the second edge light source 32b to travel the reflected light to the second edge viewpoint V21.

The reflective surface 121-1 may have a flat shape. The reflective surface 121-1 may be formed as a plane. The reflective surface 121-1 may have an inclination of a certain angle with respect to the first direction Z. The reflective surface 121-1 may be inclined with respect to the first direction Z to become closer to the lens axis LL in the second direction X as a distance from the second light source 32 increases.

The angle of the reflective surface 121-1 with respect to the first direction Z may be appropriately set such that light from the second light source 32 is totally reflected to travel toward the second viewpoint V2 in consideration of a refractive index of the reflective portion 120-1, etc.

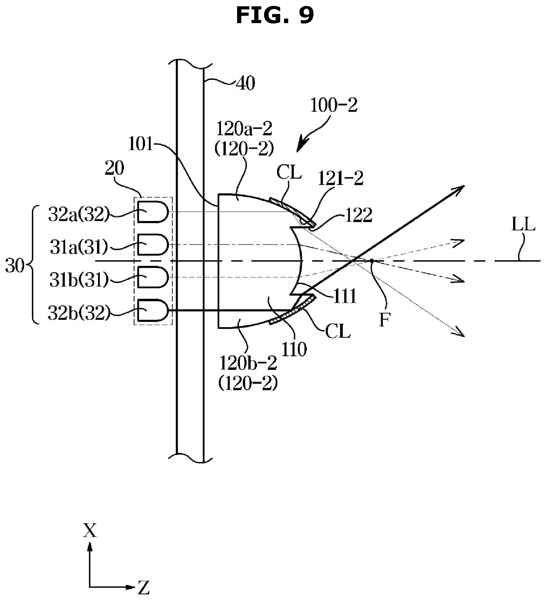

FIG. 9 is a view illustrating an example in which a multi-viewpoint lens of the display apparatus according to one or more embodiments has a coated reflective surface.

Referring to FIG. 9, a multi-viewpoint lens 100-2 of the display apparatus 1 according to an embodiment of the present disclosure may include the refractive portion 110 and a reflective portion 120-2. A detailed description of the refractive portion 110 and the reflective portion 120-2 corresponds to the description of the refractive portion 110 and the reflective portion 120 or 120-1 in the above-described embodiments, and thus a repeated description thereof may be omitted.

The reflective portion 120-2 may include a reflective surface 121-2 configured to reflect light from the second light source 32. The reflective surface 121-1 may be configured to reflect light from the second light source 32 to travel the reflected light to the second viewpoint V2. A coating layer CL may be coated on the reflective surface 121-2. For example, the coating layer CL may be coated on an outer side of the reflective surface 121-2. For example, the coating layer CL may include a material with high light reflectivity, such as chromium (Cr). For example, the coating layer CL may be formed by plating a material having relatively high light reflectivity on the outer side of the reflective surface 121-2. By forming the coating layer CL on the reflective surface 121-2, light reflection efficiency on reflective surface 121-2 may be further improved.

For example, a first reflective portion 120a-2 may include a reflective surface 121-2 configured to reflect light from the first edge light source 32a to travel the reflected light to the first edge viewpoint V22, and the coating layer CL may be coated on the reflective surface 121-2 of the first reflective portion 120a-2. For example, a second reflective portion 120b-2 may include a reflective surface 121-2 configured to reflect light from the second edge light source 32b to travel the reflected light to the second edge viewpoint V21, and the coating layer CL may be coated on the reflective surface 121-2 of the second reflective portion 120b-2.

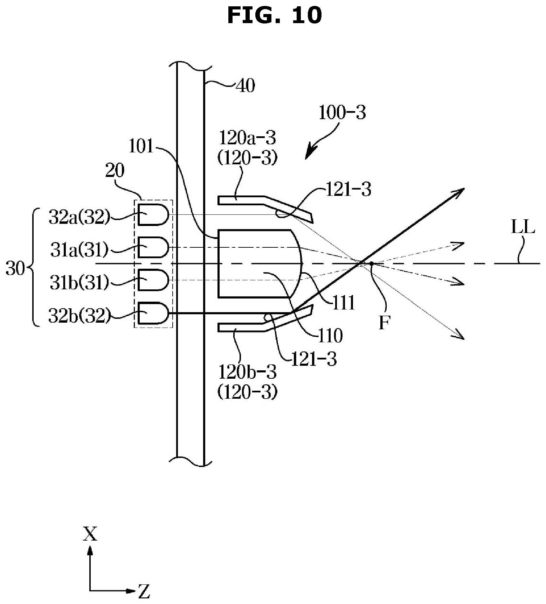

FIG. 10 is a view illustrating an example in which a multi-viewpoint lens of the display apparatus according to one or more embodiments has a reflective portion including a mirror.

Referring to FIG. 10, a multi-viewpoint lens 100-3 of the display apparatus 1 according to an embodiment of the present disclosure may include the refractive portion 110 and a reflective portion 120-3. A detailed description of the refractive portion 110 and the reflective portion 120-3 corresponds to the description of the refractive portion 110 and the reflective portion 120 or 120-2 in the above-described embodiments, and thus a repeated description thereof may be omitted.

According to an embodiment, the reflective portion 120-3 of the multi-viewpoint lens 100-3 may be formed separately and spaced apart from the refractive portion 110. The reflective portion 120-3 may not be connected to the refractive portion 110.

According to an embodiment, the reflective portion 120-3 of the multi-viewpoint lens 100-3 may include a mirror configured to reflect light from the second light source 32. The reflective portion 120-3 may include a reflective surface 121-3, and the mirror may be provided on at least the reflective surface 121-3 of the reflective portion 120-3. The mirror provided on the reflective surface 121-3 may be inclined with respect to the first direction Z to become closer to the lens axis LL in the second direction X as a distance away from the second light source 32 in the first direction Z increases.

For example, the mirror provided on the reflective surface 121-3 may have a structure in which a material with relatively high light reflectivity, such as chrome, is coated on one surface of a material such as glass or transparent plastic. In addition, the mirror of the reflective surface 121-3 may include mirrors of various structures that are known or will be known in the future.

As such, the reflective portion 120-3 may include a mirror to reflect light, and light emitted from the second light source 32 may enter the reflective portion 120-3, be directly reflected by the mirror of the reflective surface 121-3 without passing through the reflective portion 120-3, and travel to the second viewpoint V2.

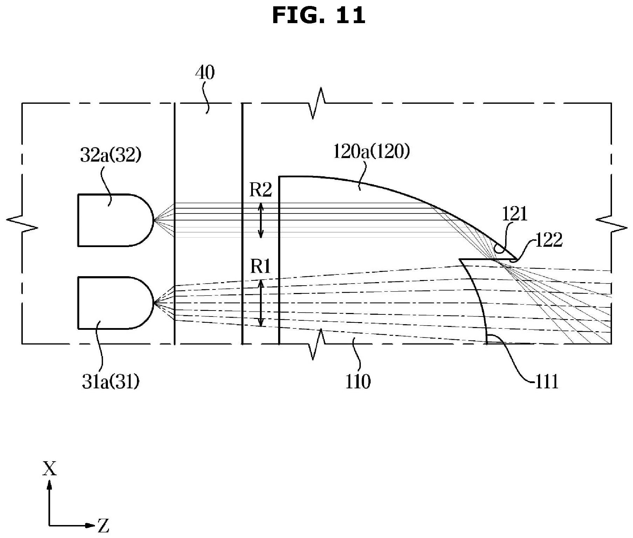

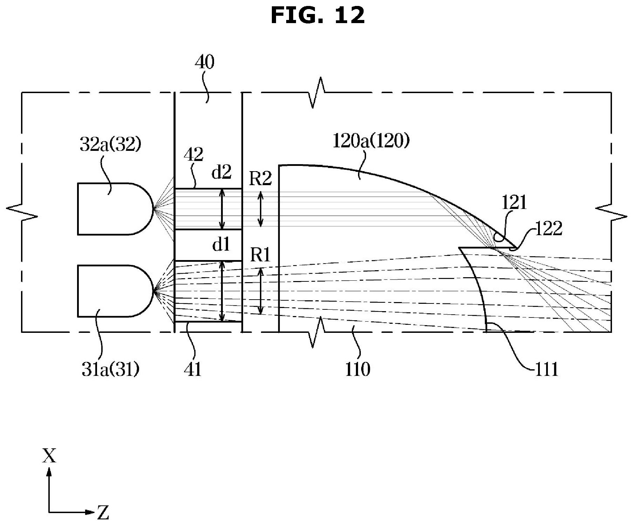

FIG. 11 is a view illustrating that light emitted from a plurality of the light sources of the display apparatus according to one or more embodiments passes through the optical sheet. FIG. 12 is a view illustrating that light emitted from the plurality of light sources of the display apparatus according to one or more embodiments passes through holes of the optical sheet.

Referring to FIGS. 11 and 12, the display apparatus 1 according to an embodiment of the present disclosure may include the optical sheet 40 configured to change characteristics of light incident on the multi-viewpoint lens 100. The optical sheet 40 may be disposed between the light source array 20 and the multi-viewpoint lens 100. The optical sheet 40 may be disposed between the plurality of light sources 30 and the multi-viewpoint lens 100.

In various embodiments, an image provided at the second viewpoint V2 by light emitted from the second light source 32 and reflected by the reflective portion 120 and an image provided at the first viewpoint V1 by light emitted from the first light source 31 and refracted by the refractive portion 110 may not overlap with each other to improve an image quality. When the image provided to the first viewpoint V1 and the image provided to the second viewpoint V2 overlap each other, the image quality of the entire image may deteriorate.

Because the light emitted from the second light source 32 must be incident on the reflective portion 120 adjacent to an edge of each of the multi-viewpoint lenses 100, be bent at a relatively large angle, and then travel to the second viewpoint V2, in order to avoid overlapping with the light from the first light source 31 in the viewing area, it is appropriate for a range of light (i.e., an emission width of light) to be relatively small. For example, in order to prevent crosstalk of images between the plurality of viewpoints V and improve the image quality, an emission range of light emitted from the second light source 32 and incident on the reflective portion 120 may be smaller than an emission range of light emitted from the first light source 31 and incident on the refractive portion 110.

In order to implement this function, the optical sheet 40 may be configured to limit the range of light emitted from the first light source 31 and incident to the refractive portion 110 to a first width R1. Also, the optical sheet 40 may be configured to limit the range of light emitted from the second light source 32 and incident on the reflective portion 120 to a second width R2 smaller than the first width R1. By this configuration, a range width of light incident on the reflective portion 120 may be smaller than a range width of light incident on the refractive portion 110, and image crosstalk at the viewpoint V may be prevented and/or reduced.

According to an embodiment, as illustrated in FIG. 12, the optical sheet 40 may include a first hole 41 provided to allow at least one part traveling to the refractive portion 110 among the light emitted from the first light source 31 to pass therethrough, and a second hole 42 provided to allow at least one part traveling to the refractive portion 120 among the light emitted from the second light source 32 to pass therethrough. For example, the first hole 41 may be configured to transmit at least a portion of the light emitted from the first light source 31, and a second hole 42 may be configured to transmit at least a portion of the light emitted from the second light source 32. Other portions of the optical sheet 40 in which the first hole 41 and the second hole 42 are not formed may be configured to limit or block the traveling of light.

A size d2 of the second hole 42 may be smaller than a size d1 of the first hole 41. Accordingly, for example, based on the emission ranges of lights emitted from the first light source 31 and the second light source 32 being substantially the same, the range of the light emitted from the second light source 32 and traveling to the reflective portion 120 may be more limited than the range of the light emitted from the first light source 31 and traveling to the refractive portion 110.

The first hole 41 and the second hole 42 of the optical sheet 40 may have the shape of a slit extending along a direction in which the multi-viewpoint lens 100 extends. For example, the first hole 41 and the second hole 42 of the optical sheet 40 may each extend in the third direction Y. As another example, the first hole 41 and the second hole 42 of the optical sheet 40 may each extend in a direction of being inclined at an angle other than 90 degrees with respect to the second direction X.

Although FIGS. 11 and 12 illustrate only the first central light source 31a of the first light source 31 and the first edge light source 32a of the second light source 32, the contents described above may be correspondingly applied to the second central light source 31b and the second edge light source 32b, respectively.

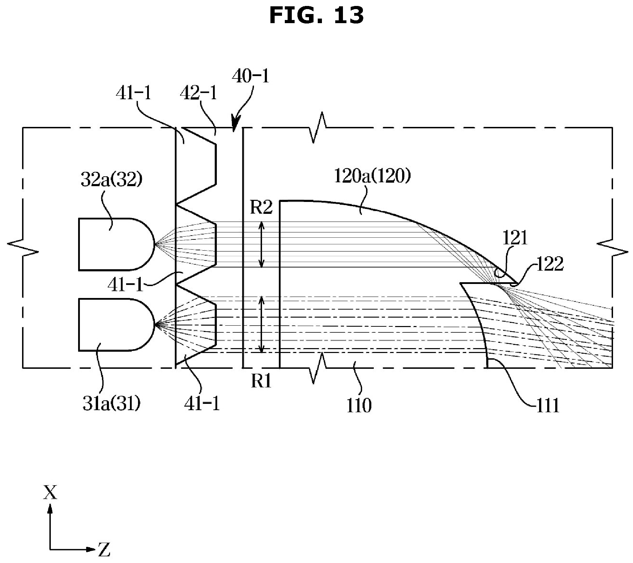

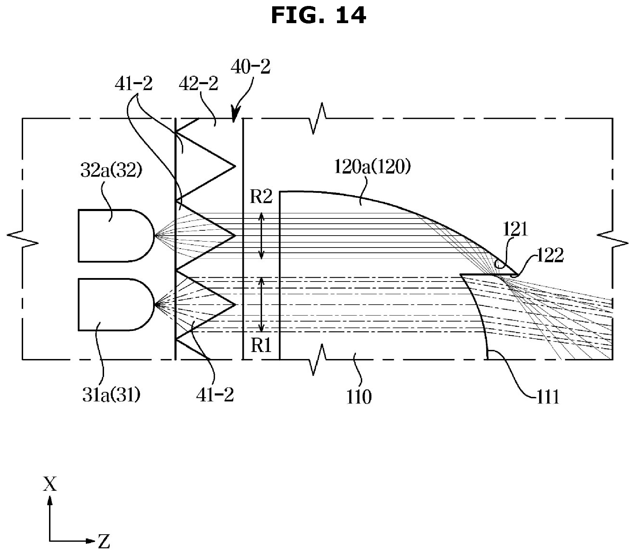

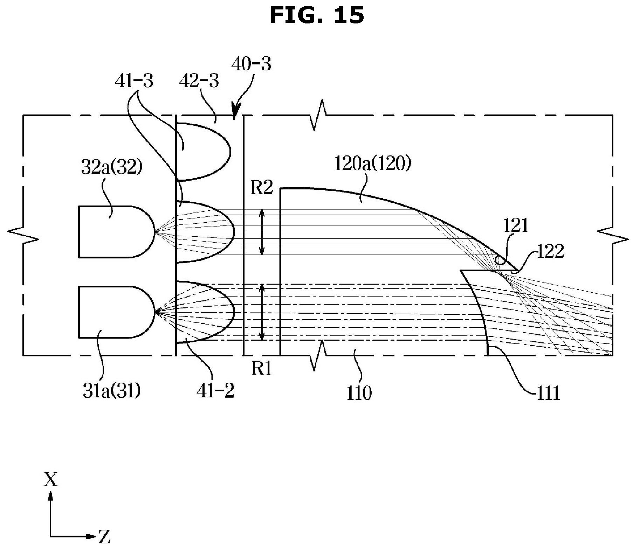

FIG. 13 is a view illustrating that light emitted from the plurality of light sources of the display apparatus according to one or more embodiments passes through an optical sheet including high refractive index portions and low refractive index portions. FIG. 14 is a view illustrating that light emitted from the plurality of light sources of the display apparatus according to one or more embodiments passes through an optical sheet including high refractive index portions and low refractive index portions. FIG. 15 is a view illustrating that light emitted from the plurality of light sources of the display apparatus according to one or more embodiments passes through an optical sheet including high refractive index portions and low refractive index portions.

Referring to FIG. 13, the display apparatus 1 according to one embodiment of the present disclosure may include an optical sheet 40-1 configured to refract light traveling from the light sources 30 to the multi-viewpoint lens 100 to limit the range of light emitted from each of the light sources 30.

The optical sheet 40-1 may include a high refractive index portion 41-1 and a low refractive index portion 42-1. The high refractive index portion 41-1 may include a material having a higher refractive index than a refractive index of a material included in the low refractive index portion 42-1. For example, light emitted from the light source 30 may be refracted while sequentially passing through the high refractive index portion 41-1 and the low refractive index portion 42-1 and then incident on the multi-viewpoint lens 100. The high refractive index portion 41-1 may be disposed closer to the light source 30, and the low refractive index portion 42-1 may be disposed closer to the multi-viewpoint lens 100. Light emitted from the light source 30 may be refracted at a surface at which the light is incident on the high refractive index portion 41-1. Light passed through the high refractive index portion 41-1 may be refracted at a boundary between the high refractive index portion 41-1 and the low refractive index portion 42-1.

The width of light emitted from the light source 30 may be limited as the light passes through the high refractive index portion 41-1 and the low refractive index portion 42-1. For example, the range of light emitted from the first light source 31 may be limited to the first width R1 as the light passes through the high refractive index portion 41-1 and the low refractive index portion 42-1, and the range of light emitted from the second light source 32 may be limited to the second width R2 smaller than the first width R1 as the light passes through the high refractive index portion 41-1 and the low refractive index portion 42-1.

In order to limit the range of light emitted from the first light source 31 and the range of light emitted from the second light source 32 to predetermined ranges, respectively, for example, refractive indices of the materials constituting the high refractive index portion 41-1 and the low refractive index portion 42-1 may be appropriately determined. For example, the refractive index of the high refractive index portion 41-1 through which light emitted from the first light source 31 passes and the refractive index of the high refractive index portion 41-1 through which light emitted from the second light source 32 passes may be different from each other. For example, the refractive index of the high refractive index portion 41-1 through which light emitted from the second light source 32 passes may be greater than the refractive index of the high refractive index portion 41-1 through which light emitted from the first light source 31 passes. As another example, the refractive index of the high refractive index portion 41-1 through which light emitted from the first light source 31 passes and the refractive index of the high refractive index portion 41-1 through which light emitted from the second light source 32 passes may be substantially the same.

In order to limit the range of light emitted from the first light source 31 and the range of light emitted from the second light source 32 to the predetermined range, respectively, for example, a shape of the boundary between the high refractive index portion 41-1 and the low refractive index portion 42-1 may be appropriately determined. The high refractive index portion 41-1 through which light emitted from the first light source 31 passes and the high refractive index portion 41-1 through which light emitted from the second light source 32 passes may have different shapes, such as a direction, length, and size of the boundary with the low refractive index portion 42-1. As another example, the high refractive index portion 41-1 through which light emitted from the first light source 31 passes and the high refractive index portion 41-1 through which light emitted from the second light source 32 passes may have substantially the same shape.

As in the embodiment illustrated in FIG. 13, the high refractive index portion 41-1 of the optical sheet 40-1 may have a substantially trapezoidal cross-section. For example, the high refractive index portion 41-1 may have a trapezoidal cross-section whose width in the second direction X becomes narrower as a distance from the light source 30 in the first direction Z increases. For example, the boundary between the high refractive index portion 41-1 and the low refractive index portion 42-1 may include a portion inclined at an angle of less than 90 degrees with respect to the first direction Z and a portion disposed at substantially 90 degrees with respect to the first direction Z. However, the shapes of the high refractive index portion 41-1 and the low refractive index portion 42-1 of the optical sheet 40-1 illustrated in FIG. 13 are only examples.

As in the embodiment illustrated in FIG. 14, the display apparatus 1 may include an optical sheet 40-2 including a high refractive index portion 41-2 and a low refractive index portion 42-2. The high refractive index portion 41-2 of the optical sheet 40-2 may have a substantially triangular cross-section. For example, the high refractive index portion 41-2 may have a triangular cross-section whose width in the second direction X becomes narrower as a distance from the light source 30 in the first direction Z increases. For example, a boundary between the high refractive index portion 41-2 and the low refractive index portion 42-2 may be inclined at an angle less than 90 degrees with respect to the first direction Z.

As in the embodiment illustrated in FIG. 15, the display apparatus 1 may include an optical sheet 40-3 including a high refractive index portion 41-3 and a low refractive index portion 42-3. The high refractive index portion 41-2 of the optical sheet 40-2 may have a substantially partially elliptical cross-section. For example, the high refractive index portion 41-2 may have a partially elliptical cross-section whose width in the second direction X becomes narrower as a distance from the light source 30 in the first direction Z increases. For example, the boundary between the high refractive index portion 41-2 and the low refractive index portion 42-2 may include a curved surface.

The cross-section of the high refractive index portion 41-1 or 41-2 or 41-3 above may be defined as a cross-section cut in a direction substantially perpendicular to the third direction Y.

Optical characteristics of the optical sheet 40-2 illustrated in FIG. 14 and the optical sheet 40-3 illustrated in FIG. 15 may correspond to the optical characteristics of the optical sheet 40-1 described with reference to FIG. 13, and thus a detailed description thereof is omitted.

By this configuration, the range width of light incident on the reflective portion 120 may be smaller than the range width of light incident on the refractive portion 110, and the image crosstalk at the viewpoint V may be prevented and/or reduced.

Although FIGS. 13 to 15 illustrate only the first central light source 31a of the first light source 31 and the first edge light source 32a of the second light source 32, the contents described above may be correspondingly applied to the second central light source 31b and the second edge light source 32b, respectively.

In various embodiments of the present disclosure, structures of optical sheets are not limited to the structures of the optical sheets 40, 40-1, 40-2, and 40-3 described above with reference to FIGS. 11 to 15, and the display apparatus 1 according to various embodiments may include various types of optical sheets.

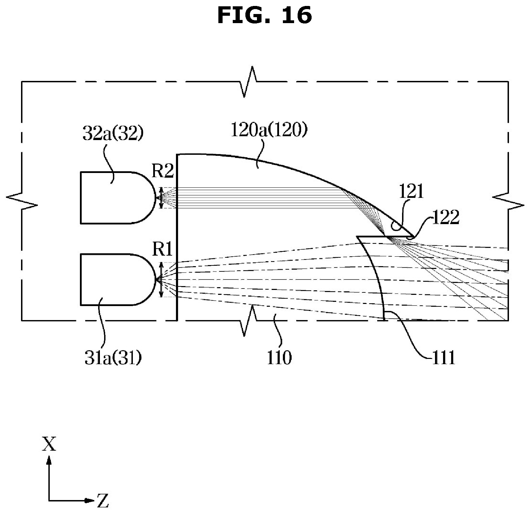

FIG. 16 is a view illustrating that light emitted from the plurality of light sources of the display apparatus according to one or more embodiments proceeds to the multi-viewpoint lens.

Referring to FIG. 16, the display apparatus 1 according to an embodiment of the present disclosure may be configured such that each of the plurality of light sources 30 emits light of a limited range width to the multi-viewpoint lens 100. The first light source 31 may be configured to emit light of a limited range width to the refractive portion 110, and the second light source 32 may be configured to emit light of a limited range width to the reflective portion 120.

For example, the first light source 31 may be configured to emit light of the first width R1 toward the refractive portion 110. The second light source 32 may be configured to emit light toward the reflective portion 120 with the second width R2 smaller than the first width R1. Each of the light sources 30 may itself include various structures that may limit an emission width of light.

In such a case, for example, the optical sheet 40 may not be provided between the light source array 20 and the multi-viewpoint lens 100. Nevertheless, because each of the plurality of light sources 30 itself emits light with the limited range width, the range width of light incident on the reflective portion 120 may be smaller than the range width of light incident on the refractive portion 110, and the image crosstalk at the viewpoint V may be prevented and/or reduced.

Although FIG. 16 illustrates only the first central light source 31a of the first light source 31 and the first edge light source 32a of the second light source 32, the contents described above may be correspondingly applied to the second central light source 31b and the second edge light source 32b, respectively.

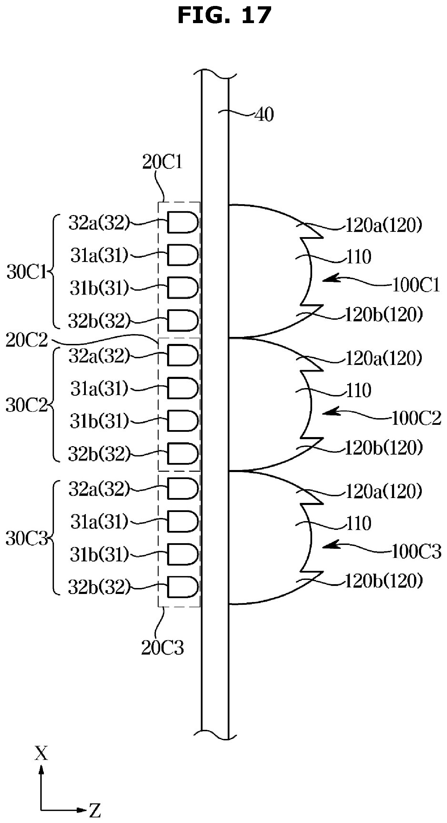

FIG. 17 is a view illustrating a plurality of light source arrays adjacent to each other and a plurality of multi-viewpoint lenses adjacent to each other included in the display apparatus according to one or more embodiments.

Referring to FIG. 17, the display apparatus 1 according to an embodiment of the present disclosure may include a plurality of light source arrays 20 defined to be partitioned from each other, and the plurality of multi-viewpoint lenses 100 each corresponding to a plurality of the light source arrays 20. In FIG. 17, the plurality of light source arrays 20 may refer to some of the light source arrays 20 among the entire light source arrays 20 of the display apparatus 1. In FIG. 17, the plurality of multi-viewpoint lenses 100 may refer to some of the multi-viewpoint lenses 100 among the entire multi-viewpoint lenses 100 of the display apparatus 1.

The plurality of light source arrays 20 may be disposed adjacent to each other. The plurality of light source arrays 20 may be disposed adjacent to each other in the second direction X.

The plurality of multi-viewpoint lenses 100 may be disposed adjacent to each other. The plurality of multi-viewpoint lenses 100 may be disposed adjacent to each other in the second direction X.

The plurality of light sources 30 included in the plurality of light source arrays 20 adjacent to each other may emit light of different colors to form at least one pixel among the plurality of pixels P on the screen S. Light emitted from the plurality of light sources 30 included in the plurality of light source arrays 20 adjacent to each other may pass through the plurality of multi-viewpoint lenses 100 and provide images of different colors, and the images of the different colors may be perceived by being combined at the plurality of viewpoints V, respectively.

This will be described in more detail below with reference to the embodiment illustrated in FIG. 17.

For example, the light source array 20 of the display apparatus 1 may include a first light source array 20C1, a second light source array 20C2, and a third light source array 20C3, which are adjacent to each other. The first light source array 20C1 may include a plurality of first color light sources 30C1 emitting light of a first color. The second light source array 20C2 may include a plurality of second color light sources 30C2 emitting light of a second color. The third light source array 20C3 may include a plurality of third color light sources 30C3 emitting light of a third color. The first color light source 30C1, the second color light source 30C2, and the third color light source 30C3 may each include the first light source 31 and the second light source 32 described above, and a repeated description thereof may be omitted.

The first color, second color and third color described above may be different colors. The first color, second color, and third color may be colors that are combined with each other to form one pixel. For example, the first color may be red, the second color may be green, and the third color may be blue, but the colors are not limited thereto.

The multi-viewpoint lens 100 of the display apparatus 1 may include a first multi-viewpoint lens 100C1, a second multi-viewpoint lens 100C2, and a third multi-viewpoint lens 100C3, which are adjacent to each other. For example, the first multi-viewpoint lens 100C1 may correspond to the first light source array 20C1. For example, the second multi-viewpoint lens 100C2 may correspond to the second light source array 20C2. For example, the third multi-viewpoint lens 100C3 may correspond to the third light source array 20C3.

As an example, the first multi-viewpoint lens 100C1, the second multi-viewpoint lens 100C2, and the third multi-viewpoint lens 100C3 may have corresponding shapes (e.g., the same shape), but are not limited thereto.

For example, light emitted from the first light source 31 of the first color light source 30C1 may travel to the first viewpoint V1 by the refractive portion 110 of the first multi-viewpoint lens 100C1. Light emitted from the first light source 31 of the second color light sources 30C2 may travel to the first viewpoint V1 by the refractive portion 110 of the second multi-viewpoint lens 100C2. Light emitted from the first light source 31 of the third color light source 30C3 may travel to the first viewpoint V1 by the refractive portion 110 of the third multi-viewpoint lens 100C3. Due to this, a combination of multicolored lights may be perceived at the first viewpoint V1.

For example, light emitted from the second light source 32 of the first color light source 30C1 may travel to the second viewpoint V2 by the reflective portion 120 of the first multi-viewpoint lens 100C1. Light emitted from the second light source 32 of the second color light source 30C2 may travel to the second viewpoint V2 by the reflective portion 120 of the second multi-viewpoint lens 100C2. Light emitted from the second light source 32 of the third color light source 30C3 may travel to the second viewpoint V2 by the reflective portion 120 of the third multi-viewpoint lens 100C3. Due to this, a combination of multicolored lights may be perceived at the second viewpoint V2.

As such, the pixel P on the screen S may be formed by a plurality of the light source arrays 20C1, 20C2, and 20C3 disposed adjacent to each other and emitting light of different colors and a plurality of the multi-viewpoint lenses 100C1, 100C2, and 100C3 corresponding thereto, an image may be provided by combining the plurality of pixels P.

The example has been described above is not limited to, in which all the light sources 30C1 in the first light source array 20C1 emit light of the same first color, all the light sources 30C2 in the second light source array 20C2 emit light of the same second color, and the all light sources 30C3 in the third light source array 20C3 emit light of the same third color. According to an embodiment, some of the light sources 30C1 included in the first light source array 20C1 may emit light of different colors, and this may also be applied to the second light source array 20C2 and the third light source array 20C3.

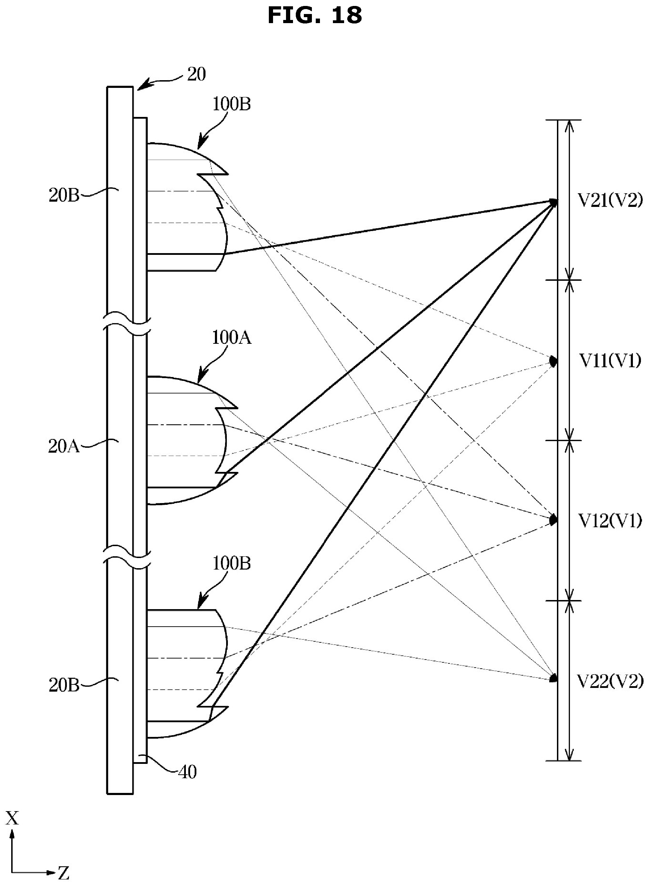

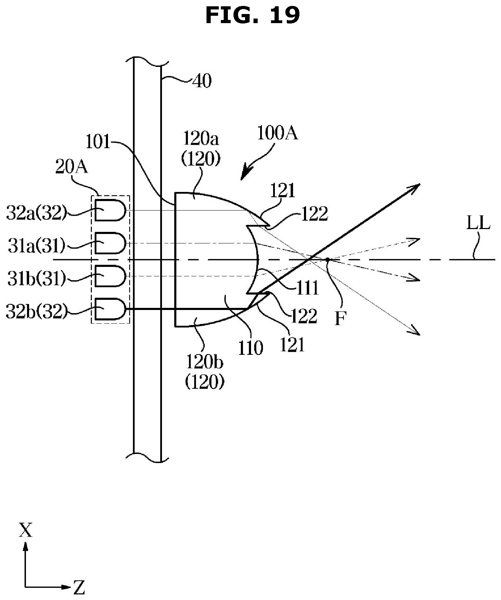

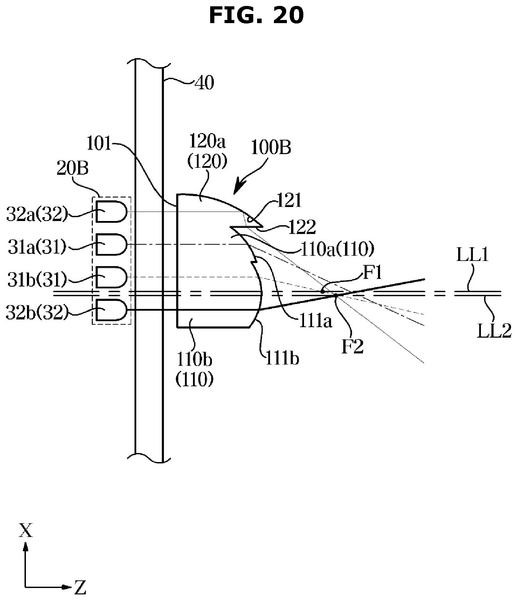

FIG. 18 is a view illustrating light source arrays, a central multi-viewpoint lens, and outer multi-viewpoint lenses of the display apparatus according to one or more embodiments. FIG. 19 is a view illustrating the light source array and the central multi-viewpoint lens of the display apparatus according to one or more embodiments. FIG. 20 is a view illustrating the light source array and the outer multi-viewpoint lens of the display apparatus according to one or more embodiments.

Referring to FIGS. 18 to 20, the display apparatus 1 according to an embodiment of the present disclosure may include the plurality of multi-viewpoint lenses 100 (e.g., a central multi-viewpoint lens 100A and an outer multi-viewpoint lens 100B) having different shapes depending on positions thereof in the display apparatus 1.

According to an embodiment, the screen S of the display apparatus 1 may extend in the second direction X. Also, according to an embodiment, the screen S of the display apparatus 1 may be disposed such that the viewer may view the screen at various positions in the second direction X.

In this case, when the multi-viewpoint lens 100 disposed in an area adjacent to the center of the screen S and the multi-viewpoint lens 100 disposed in an area adjacent to the edge of the screen S have the same shape, there is a possibility that an image may not be clearly provided to each of the plurality of viewpoints V. For example, there is a possibility that the viewing area may become narrower.

Therefore, according to an embodiment, the refractive portions 110 of each of the plurality of multi-viewpoint lenses 100 may be configured to refract lights such that lights from the first light sources 31 (e.g., the first central light source 31a and the second central light source 31b) of each of the plurality of light source arrays 20 travel toward the same first viewpoints V1 (e.g., the first central viewpoint V12 and the second central viewpoint V11). Also, the reflective portions 120 of each of the plurality of multi-viewpoint lenses 100 may be configured to reflect lights such that lights from the second light sources 32 (e.g., the first edge light source 32a and the second edge light source 32b) of each of the plurality of light source arrays 20 travel toward the same second viewpoints V2 (e.g., the first edge viewpoint V22 and the second edge viewpoint V21).

According to an embodiment, the display apparatus 1 may include a central multi-viewpoint lens 100A and an outer multi-viewpoint lens 100B having different shapes.

The display apparatus 1 may include the plurality of light source arrays 20 partitioned from each other. For example, the plurality of light source arrays 20 may include a central light source array 20A disposed in an area adjacent to the center in the second direction X of the screen S, and an outer light source array 20B disposed in the second direction X of the central light source array 20A. For example, the outer light source array 20B may be disposed further outward than the central light source array 20A in the second direction X. For example, the outer light source array 20B may be disposed in an area adjacent to an edge in the second direction X of the screen S.

The central light source array 20A and the outer light source array 20B may each include the first light source 31 (e.g., the first central light source 31a and the second central light source 31b) and the second light source 32 (e.g., the first edge light source 32a and the second edge light source 32b).

The central multi-viewpoint lens 100A may correspond to the central light source array 20A. The central multi-viewpoint lens 100A may be disposed adjacent to the central light source array 20A. The central multi-viewpoint lens 100A may be disposed in the first direction Z of the central light source array 20A. The refractive portion 110 of the central multi-viewpoint lens 100A may refract light from the first light source 31 of the central light source array 20A to travel the refracted light to the first viewpoint V1. For example, the refractive portion 110 of the central multi-viewpoint lens 100A may refract light from the first central light source 31a of the central light source array 20A to travel the refracted light to the first central viewpoint V12, and may refract light from the second central light source 31b of the central light source array 20A to travel the refracted light to the second central viewpoint V11. The reflective portion 120 of the central multi-viewpoint lens 100A may reflect light from the second light source 32 of the central light source array 20A to travel the reflected light to the second viewpoint V2. For example, the first reflective portion 120a of the central multi-viewpoint lens 100A may refract light from the first edge light source 32a of the central light source array 20A to travel the refracted light to the first edge viewpoint V22, and the second reflective portion 120b of the central multi-viewpoint lens 100A may refract light from the second edge light source 32b of the central light source array 20A to travel the refracted light to the second edge viewpoint V21.

According to an embodiment, a configuration of the central multi-viewpoint lens 100A corresponds to the configuration of the multi-viewpoint lens 100 described with reference to FIGS. 5 to 17, and thus a detailed description thereof may be omitted.

The outer multi-viewpoint lens 100B may correspond to the outer light source array 20B. The outer multi-viewpoint lens 100B may be disposed adjacent to the outer light source array 20B. The outer multi-viewpoint lens 100B may be disposed in the first direction Z of the outer light source array 20B. The refractive portion 110 of the outer multi-viewpoint lens 100B may refract light from the first light source 31 of the outer light source array 20B to travel the refracted light to the first viewpoint V1. The reflective portion 120 of the outer multi-viewpoint lens 100B may reflect light from the second light source 32 of the outer light source array 20B to travel the reflected light to the second viewpoint V2.

Because the outer multi-viewpoint lens 100B is disposed to be at one side in the second direction X with respect to the center of the screen S, the outer multi-viewpoint lens 100B may have an asymmetrical shape so that lights are emitted biased to the one side with respect to the second direction X. As illustrated in FIGS. 18 and 20, the outer multi-viewpoint lens 100B may have an asymmetrical shape with respect to the center of the outer multi-viewpoint lens 100B in the second direction X.

For example, as illustrated in FIG. 20, the outer multi-viewpoint lens 100B may include the reflective portion 120 and the refractive portion 110. The reflective portion 120 of the outer multi-viewpoint lens 100B may have a similar shape to one of the reflective portions 120 of the central multi-viewpoint lens 100A (the first reflective portion 120a or the second reflective portion 120b). However, the reflective portion 120 of the outer multi-viewpoint lens 100B may be configured to bend the traveling direction of light from the second light source 32 at a larger angle than the reflective portion 120 of the central multi-viewpoint lens 100A. For example, an angle at which the traveling direction of light emitted from the reflective portion 120 included in the outer multi-viewpoint lens 100B is inclined with respect to the first direction Z may be larger than an angle at which the traveling direction of light emitted from the reflective portion 120 included in the central multi-viewpoint lens 100A is inclined with respect to the first direction Z.

For example, the refractive portion 110 of the outer multi-viewpoint lens 100B may be configured to refract light from the first central light source 31a and the second central light source 31b. For example, the refractive portion 110 of the outer multi-viewpoint lens 100B may refract light from the first central light source 31a of the outer light source array 20B to travel the refracted light to the first central viewpoint V12, and may refract light from the second central light source 31b of the outer light source array 20B to travel the refracted light to the second central viewpoint V11.

For example, the refractive portion 110 may include a plurality of refractive portions having different curvatures (e.g., a first refractive portion 110a and a second refractive portion 110b). An emission surface 111a of the first refractive portion 110a and an emission surface 111b of the second refractive portion 110b may have different radii of curvature or may be discontinuously connected to each other. For example, light from the first central light source 31a may be refracted by the first refractive portion 110a, and light from the second central light source 31b may be refracted by the second refractive portion 110b. However, the present disclosure is not limited thereto, and in an embodiment, the refractive portion 110 may include a continuous emission surface or may have a uniform radius of curvature.

In an embodiment, when the reflective portion 120 of the outer multi-viewpoint lens 100B is configured to reflect light from the first edge light source 32a of the second light source 32 to the first edge viewpoint V22, light from the second edge light source 32b may be refracted by the refractive portion 110 of the outer multi-viewpoint lens 100B and travel to the second edge viewpoint V21. For example, light from the second edge light source 32b may be refracted by the second refractive portion 110b of the outer multi-viewpoint lens 100B and travel to the second edge viewpoint V21.

The reflective portion 120 of the outer multi-viewpoint lens 100B may reflect light emitted from the first edge light source 32a to intersect a lens axis passing through a focus of the refractive portion 110 (e.g., a first lens axis LL1 passing through a first focus F1 and/or a second lens axis LL2 passing through a second focus F2) and travel to the first edge viewpoint V22.

The refractive portion 110 (e.g., the second refractive portion 110b) of the outer multi-viewpoint lens 100B may refract light emitted from the second edge light source 32b to intersect the lens axis passing through the focus of the refractive portion 110 (e.g., the first lens axis LL1 passing through the first focus F1 and/or the second lens axis LL2 passing through the second focus F2) and travel to the second edge viewpoint V21.

By this configuration, the display apparatus 1 may provide an overall viewing area by using a plurality of multi-viewpoint lenses 100 having different shapes depending on positions thereof in the second direction X on the screen S, and the provided viewing area may have a wide width.

In the display apparatus 1 according to an embodiment, the plurality of multi-viewpoint lenses 100 may be disposed relatively close to the plurality of light source arrays 20 to provide the overall viewing area. For example, the plurality of multi-viewpoint lenses 100 may be attached to and contact the front surfaces of the plurality of light source arrays 20 or to the front surface of the optical sheet 40. In this case, lights emitted from the plurality of light source arrays 20 may only be incident on the corresponding multi-viewpoint lenses 100, and images resulting from lights being incident on the non-corresponding multi-viewpoint lenses 100 may be prevented from being repeatedly perceived at viewpoints.

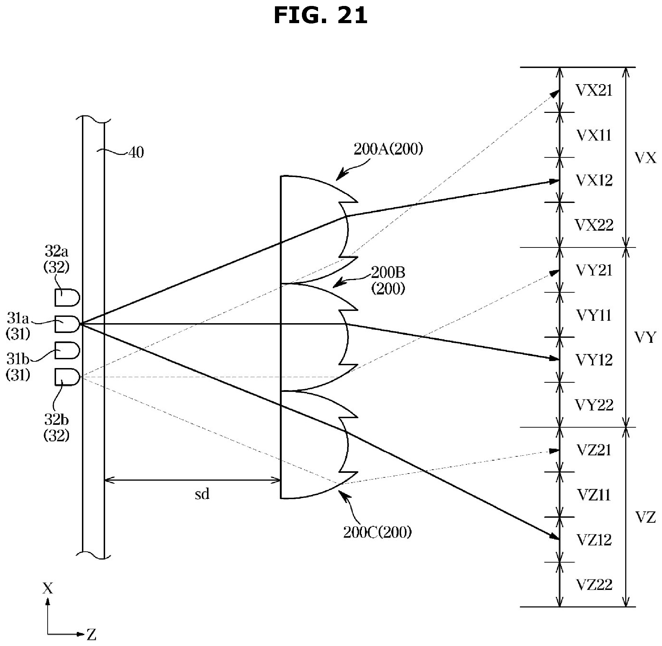

FIG. 21 is a view illustrating that the light source arrays and the multi-viewpoint lenses of the display apparatus according to one or more embodiments are spaced apart from each other by a predetermined distance.

In description of some components of the display apparatus 1 according to an embodiment of the present disclosure with reference to FIG. 21, components corresponding to those of the embodiments described with reference to FIGS. 1 to 20 are given the same reference numerals, and repeated descriptions thereof may be omitted.

Referring to FIG. 21, in the display apparatus 1 according to an embodiment of the present disclosure, a multi-viewpoint lens 200 may be spaced apart from the light source array 20 in the first direction Z.

The multi-viewpoint lens 200 may be located at a separation distance sd from the light source array 20 in the first direction Z. The separation distance sd may be determined as a distance at which light from the specific light source 30 of the light source array 20 may be simultaneously incident on two or more ones of the plurality of multi-viewpoint lenses 200.

For example, as illustrated in FIG. 21, light emitted from any one of the light sources 30 included in the light source array 20 may be simultaneously incident on each of a first multi-viewpoint lens 200A, a second multi-viewpoint lens 200B, and a third multi-viewpoint lens 200C, and may travel after being refracted or reflected by each of the lenses.

In this case, using the multi-viewpoint lens 200, the display apparatus 1 may provide a plurality of viewing areas with a wide range, and the same image may be perceived repeatedly in each viewing area.

For example, as illustrated in FIG. 21, the display apparatus 1 may provide an X viewing area VX, a Y viewing area VY, and a Z viewing area VZ, which are partitioned from each other. The X viewing area VX, the Y viewing area VY, and the Z viewing area VZ may be arranged to be partitioned from each other in the second direction X.

The plurality of viewing areas VX, VY, and VZ may each include a plurality of viewpoints partitioned from each other.

For example, the X viewing area VX may include viewpoints VX11 and VX12 to which light emitted from the first light source 31 travels while passing through one of the plurality of multi-viewpoint lenses 200 (e.g., the first multi-viewpoint lens 200A). Also, the X viewing area VX may include viewpoints VX21 and VX22 to which light emitted from the second light source 32 travels while passing through one of the plurality of multi-viewpoint lenses 200 (e.g., the first multi-viewpoint lens 200A).

For example, the Y viewing area VY may include viewpoints VY11 and VY12 to which light emitted from the first light source 31 travels while passing through one of the plurality of multi-viewpoint lenses 200 (e.g., the second multi-viewpoint lens 200B). Also, the Y viewing area VY may include viewpoints VY21 and VY22 to which light emitted from the second light source 32 travels while passing through one of the plurality of multi-viewpoint lenses 200 (e.g., the second multi-viewpoint lens 200B).

For example, the Z viewing area VZ may include viewpoints VZ11 and VZ12 to which light emitted from the first light source 31 travels while passing through one of the plurality of multi-viewpoint lenses 200 (e.g., the third multi-viewpoint lens 200C). Also, the Z viewing area VZ may include viewpoints VZ21 and VZ22 to which light emitted from the second light source 32 travels while passing through one of the plurality of multi-viewpoint lenses 200 (e.g., the third multi-viewpoint lens 200C).

For convenience of illustration, FIG. 21 illustrates only a case in which light emitted from the first central light source 31a of the first light sources 31 travels to the first central viewpoints VX12, VY12, and VZ12 of the viewing areas VX, VY, and VZ, respectively, and a case in which light emitted from the second edge light source 32b of the second light sources 32 travels to the second central viewpoints VX21, VY21, and VZ21 of the viewing areas VX, VY, and VZ, respectively. Light emitted from the second central light source 31b of the first light source 31 may also travel to the second central viewpoints VX11, VY11, and VZ11 of the viewing areas VX, VY, and VZ, respectively. Also, light emitted from the first central light source 32a of the second light source 32 may travel to the first edge viewpoints VX22, VY22, and VZ22 of the viewing areas VX, VY, and VZ, respectively.

For example, an image perceived from the first central viewpoint VX12 of the X viewing area VX, an image perceived from the first central viewpoint VY12 of the Y viewing area YV, and an image perceived from the first central viewpoint VZ12 of the Z viewing area VZ may be substantially the same. For example, an image perceived from the second central viewpoint VX11 of the X viewing area VX, an image perceived from the second central viewpoint VY11 of the Y viewing area YV, and an image perceived from the second central viewpoint VZ11 of the Z viewing area VZ may be substantially the same. For example, an image perceived from the first edge viewpoint VX22 of the X viewing area VX, an image perceived from the first edge viewpoint VY22 of the Y viewing area YV, and an image perceived from the first edge viewpoint VZ22 of the Z viewing area VZ may be substantially the same. For example, an image perceived from the second edge viewpoint VX21 of the X viewing area VX, an image perceived from the second edge viewpoint VY21 of the Y viewing area YV, and an image perceived from the second edge viewpoint VZ21 of the Z viewing area VZ may be substantially the same.

According to various embodiments, in order to prevent image noise, each of the light sources 30 may be configured to emit light restrictively toward a specific portion included in a specific multi-viewpoint lens (e.g., the first multi-viewpoint lens 200A, second multi-viewpoint lens 200B, and third multi-viewpoint lens 200C) among the plurality of multi-viewpoint lenses 200. For example, each of the first light sources 31 may be configured to emit light restrictively to only the refractive portion of a specific multi-viewpoint lens among the plurality of multi-viewpoint lenses 200. For example, each of the second light sources 32 may be configured to emit light restrictively toward a specific portion included in a specific multi-viewpoint lens (e.g., the first multi-viewpoint lens 200A, second multi-viewpoint lens 200B, and third multi-viewpoint lens 200C) among the plurality of multi-viewpoint lenses 200. In various embodiments, various optical members configured to limit the traveling of light may be provided in front of each of the plurality of light sources 30.

A configuration of the multi-viewpoint lens 200 corresponds to the lenticular lens (100, etc.) described with reference to FIGS. 1 to 20, and thus a repeated description thereof will be omitted.

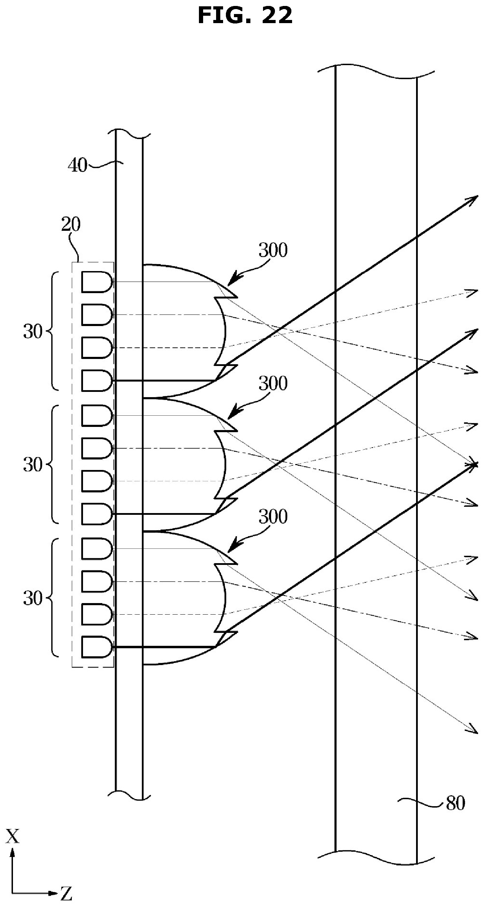

FIG. 22 is a view illustrating the light source array, multi-viewpoint lenses, and a display panel of the display apparatus according to one or more embodiments.

In description of some components of the display apparatus 1 according to an embodiment of the present disclosure with reference to FIG. 22, components corresponding to those of the embodiments described with reference to FIGS. 1 to 21 are given the same reference numerals, and repeated descriptions thereof may be omitted.

Referring to FIG. 22, the display apparatus 1 according to an embodiment of the present disclosure may include a display panel 80 disposed in the first direction Z (i.e., front) of the light source array 20. In this case, the light source array 20 may function as a backlight unit. The light source array 20 as a backlight unit may provide monochromatic light such as white and blue. The display panel 80 may include, for example, a liquid crystal display (LCD) panel.

A multi-viewpoint lens 300 according to an embodiment may be disposed between the light source array 20 and the display panel 80. The multi-viewpoint lens 300 may control a traveling path of light from the light source array 20 to emit light to the display panel 80.

A configuration of the multi-viewpoint lens 200 corresponds to the multi-viewpoint lens (100, etc.) described with reference to FIGS. 1 to 20, and thus a repeated description thereof will be omitted.

A display apparatus according to an embodiment of the present disclosure may be a display apparatus configured to provide a plurality of different images to a plurality of viewpoints. The display apparatus may include a light source array configured to emit light in a first direction, and a multi-viewpoint lens disposed in the first direction of the light source array. The light source array may include a first light source configured to emit light for providing an image to a first viewpoint among the plurality of viewpoints, and a second light source disposed in a second direction different from the first direction of the first light source and configured to emit light for providing an image to a second viewpoint disposed in the second direction of the first viewpoint among the plurality of viewpoints. The multi-viewpoint lens may include a refractive portion configured to refract light emitted from the first light source to travel the refracted light to the first viewpoint, and a reflective portion disposed in the second direction of the refractive portion and configured to reflect light emitted from the second light source to travel the reflected light to the second viewpoint.

The refractive portion may have a lens axis passing through a focus of the refractive portion in the first direction. The reflective portion may include a reflective surface inclined with respect to the first direction to become closer to the lens axis in the second direction as a distance from the second light source increases.

The reflective portion may be configured to have a predetermined refractive index. The reflective portion may include a reflective surface provided to totally reflect light incident from the second light source to the reflective portion.

The reflective portion may further include a refractive surface located at a position to which light reflected by the reflective surface travels. The refractive surface may be provided to refract light reflected by the reflective surface so that an angle thereof inclined with respect to the first direction becomes small.

The second light source may include a first edge light source disposed on one side in the second direction from the first light source, and a second edge light source disposed on another side opposite to the first edge light source in the second direction from the first light source. The reflective portion may include a first reflective portion disposed on one side in the second direction from the refractive portion and configured to reflect light emitted from the first edge light source, and a second reflective portion disposed on another side opposite to the first reflective portion in the second direction from the refractive portion and configured to reflect light emitted from the second edge light source.

The second viewpoint may include a first edge viewpoint disposed on one side in the second direction from the first viewpoint, and a second edge viewpoint disposed on another side opposite to the first edge viewpoint in the second direction from the first viewpoint. The first reflective portion may be configured to reflect light from the first edge light source to the first edge viewpoint. The second reflective portion may be configured to reflect light from the second edge light source to the second edge viewpoint.

The multi-viewpoint lens may be adjacent to one surface of the light source array in the first direction.

The display apparatus may further include an optical sheet disposed between the light source array and the multi-viewpoint lens. The optical sheet may be configured to limit a range of light emitted from the first light source and incident on the refractive portion to a first width. The optical sheet may be configured to limit a range of light emitted from the second light source and incident on the reflective portion to a second width smaller than the first width.

The optical sheet may include a first hole provided to allow at least a portion traveling to the refractive portion among the light emitted from the first light source to pass therethrough, and a second hole disposed in the second direction of the first hole and provided to allow at least a portion traveling to the reflective portion among the light emitted from the second light source to pass therethrough. A size of the second hole may be smaller than a size of the first hole.

The first light source may be configured to emit light toward the refractive portion in a range of the first width. The second light source may be configured to emit light toward the reflective portion in a range of the second width smaller than the first width.

The light source array may include a plurality of light source arrays partitioned from each other. The multi-viewpoint lens may include a plurality of multi-viewpoint lenses each corresponding to the plurality of light source arrays. The refractive portions of each of the plurality of multi-viewpoint lenses may be configured to refract lights such that lights from the first light sources of each of the plurality of light source arrays travel toward the same first viewpoints. The reflective portions of each of the plurality of multi-viewpoint lenses may be configured to reflect lights such that lights from the second light sources of each of the plurality of light source arrays travel toward the same second viewpoints.

The light source array may include a plurality of light source arrays partitioned from each other. The plurality of light source arrays may include a central light source array disposed at a center of the plurality of light source arrays in the second direction, and an outer light source array located in the second direction of the central light source array. The multi-viewpoint lens may include a plurality of multi-viewpoint lenses. The plurality of multi-viewpoint lenses may include a central multi-viewpoint lens disposed in the first direction of the central light source array, and an outer multi-viewpoint lens disposed in the first direction of the outer light source array.

The outer multi-viewpoint lens may have an asymmetric shape with respect to a center of the outer multi-viewpoint lens in the second direction.

An angle at which a traveling direction of light emitted from the reflective portion included in the outer multi-viewpoint lens is inclined with respect to the first direction may be larger than an angle at which a traveling direction of light emitted from the reflective portion included in the central multi-viewpoint lens is inclined with respect to the first direction.

The first direction and the second direction may be perpendicular to each other. The multi-viewpoint lens may extend in a third direction different from the first direction and the second direction.

A display apparatus according to an embodiment of the present disclosure may include a light source array configured to emit light in a first direction and including a first light source and a second light source arranged in a second direction different from the first direction, and a multi-viewpoint lens disposed in the first direction of the light source array. The multi-viewpoint lens may include a refractive portion configured to refract light emitted from the first light source, and a reflective portion disposed in the second direction of the refractive portion and configured to reflect light emitted from the second light source to intersect a lens axis passing through a focus of the refractive portion in the first direction.

The reflective portion may include a reflective surface inclined with respect to the first direction to become closer to the lens axis, which passes through the focus of the refractive portion, in the second direction the farther away from the second light source.

The second light source may include a first edge light source disposed on one side in the second direction from the first light source, and a second edge light source disposed on the other side opposite to the first edge light source in the second direction from the first light source. The reflective portion may include a first reflective portion disposed on one side in the second direction from the refractive portion and configured to reflect light emitted from the first edge light source to intersect the lens axis, and a second reflective portion disposed on the other side opposite to the first reflective portion in the second direction from the refractive portion and configured to reflect light emitted from the second edge light source to intersect the lens axis.

A display apparatus according to an embodiment of the present disclosure may include a light source array in which a plurality of light sources is arranged, and a multi-viewpoint lens disposed in front of the light source array. The plurality of light sources may include a first light source configured to emit first light for providing a first image, and a second light source configured to emit second light for providing a second image different from the first image. The multi-viewpoint lens may include a refractive portion configured to refract the first light in front of the first light source to travel the refracted first light to a first viewpoint, and a reflective portion disposed adjacent to the refractive portion in front of the second light source and configured to reflect the second light to intersect the first light to travel the reflected second light to a second viewpoint partitioned from the first viewpoint.

An angle at which a direction in which the second light emitted from the reflective portion travels is inclined with respect to a front-rear direction of the light source array may be larger than an angle at which a direction in which the first light emitted from the refractive portion travels is inclined with respect to the front-rear direction of the light source array.

According to the present disclosure, a display apparatus may provide different images to a plurality of viewpoints by including a multi-viewpoint lens disposed in front of a light source array.

According to the present disclosure, the display apparatus may increase a range of light in a traveling direction and expand an area of the plurality of viewpoints by including the multi-viewpoint lens including a refractive portion and a reflective portion.

According to the present disclosure, the display apparatus may reduce overlapping of images at the viewpoints by controlling the traveling direction of light using the refractive portion and reflective portion of the multi-viewpoint lens, thereby reducing image noise and improving image quality.

According to the present disclosure, the display apparatus may reduce image noise and improve image quality by including an optical sheet disposed between the multi-viewpoint lens and the light source array and controlling a range of light incident on the multi-viewpoint lens, or a light source having such a structure.

According to the present disclosure, the display apparatus may prevent the brightness of an image from deteriorating while expanding the area of the plurality of viewpoints by using the refractive portion and reflective portion of the multi-viewpoint lens.

Effects according to the present disclosure are not limited to the effects mentioned above, and other effects not mentioned will be clearly understood by those skilled in the art to which the present disclosure belongs from the fallowing description.

The foregoing has illustrated and described specific embodiments. However, it should be understood by those of skilled in the art that the present disclosure is not limited to the above-described embodiments, and various changes and modifications may be made without departing from the technical idea of the present disclosure described in the following claims and their equivalents.

## Claims

1. A display apparatus, which is configured to provide a plurality of different images to a plurality of viewpoints, comprising:
a light source array configured to emit light in a first direction; and
a multi-viewpoint lens adjacent to the light source array in the first direction,
wherein the light source array comprises:
a first light source configured to emit light to provide an image to a first viewpoint among the plurality of viewpoints; and
a second light source adjacent to the first light source in a second direction different from the first direction, the second light source being configured to emit light to provide an image to a second viewpoint among the plurality of viewpoints adjacent to the first viewpoint in the second direction, and
wherein the multi-viewpoint lens comprises:
a refractive portion configured to refract light emitted from the first light source to the first viewpoint; and
a reflective portion adjacent to the refractive portion in the second direction, the reflective portion being configured to reflect light emitted from the second light source to the second viewpoint.

2. The display apparatus according to claim 1, wherein the refractive portion has a lens axis passing through a focus of the refractive portion in the first direction, and
wherein the reflective portion comprises a reflective surface inclined with respect to the first direction such that as a distance from the second light source to the reflective portion increases in the second direction, a distance between the reflective portion and the lens axis decreases.

3. The display apparatus according to claim 1, wherein the reflective portion has a predetermined refractive index, and
wherein the reflective portion comprises a reflective surface configured to totally reflect light incident from the second light source to the reflective portion.

4. The display apparatus according to claim 3, wherein the reflective portion further comprises a refractive surface configured to receive light reflected by the reflective surface, and
wherein the refractive surface is configured to refract light reflected by the reflective surface so that an angle of the refracted light inclined with respect to the first direction decreases.

5. The display apparatus according to claim 1, wherein the second light source comprises a first edge light source on a first side of the first light source in the second direction, and a second edge light source on a second side of the first light source opposite to the first side of the first light source, and
wherein the reflective portion comprises:
a first reflective portion on a first side of the refractive portion in the second direction, the first reflective portion configured to reflect light emitted from the first edge light source; and
a second reflective portion on a second side of the refractive portion opposite to the first side of the refractive portion, the second reflective portion being configured to reflect light emitted from the second edge light source.

6. The display apparatus according to claim 5, wherein the second viewpoint comprises:
a first edge viewpoint on a first side of the first viewpoint in the second direction; and
a second edge viewpoint on a second side of the first viewpoint opposite to the first side of the first viewpoint,
wherein the first reflective portion is configured to reflect light from the first edge light source to the first edge viewpoint, and
wherein the second reflective portion is configured to reflect light from the second edge light source to the second edge viewpoint.

7. The display apparatus according to claim 1, wherein the multi-viewpoint lens is adjacent to a surface of the light source array in the first direction.

8. The display apparatus according to claim 1, further comprising
an optical sheet between the light source array and the multi-viewpoint lens,
wherein the optical sheet is configured to:
limit a range of light emitted from the first light source and incident on the refractive portion to a first width; and
limit a range of light emitted from the second light source and incident on the reflective portion to a second width smaller than the first width.

9. The display apparatus according to claim 8, wherein the optical sheet comprises:
a first hole configured to transmit at least a portion of the light emitted from the first light source and traveling to the refractive portion; and
a second adjacent to the first hole in the second direction and configured to transmit at least a portion of the light emitted from the second light source and traveling to the reflective portion, and
wherein a size of the second hole is smaller than a size of the first hole.

10. The display apparatus according to claim 1, wherein the first light source is configured to emit light toward the refractive portion in a range of a first width, and
wherein the second light source is configured to emit light toward the reflective portion in a range of a second width smaller than the first width.

11. The display apparatus according to claim 1, wherein the light source array comprises a plurality of light source arrays partitioned from each other,
wherein the multi-viewpoint lens comprises a plurality of multi-viewpoint lenses corresponding to the plurality of light source arrays, respectively,
wherein the refractive portions of each of the plurality of multi-viewpoint lenses are configured to refract lights such that lights from the first light sources of each of the plurality of light source arrays travel toward the same first viewpoints, and
wherein the reflective portions of each of the plurality of multi-viewpoint lenses are configured to reflect lights such that lights from the second light sources of each of the plurality of light source arrays travel toward the same second viewpoints.

12. The display apparatus according to claim 1, wherein the light source array comprises a plurality of light source arrays partitioned from each other,
wherein the plurality of light source arrays comprises:
a central light source array at a center of the plurality of light source arrays in the second direction; and
an outer light source array adjacent to the central light source array in the second direction,
wherein the multi-viewpoint lens comprises a plurality of multi-viewpoint lenses, and
wherein the plurality of multi-viewpoint lenses comprises:
a central multi-viewpoint lens adjacent to the central light source array in the first direction; and
an outer multi-viewpoint lens adjacent to the outer light source array in the first direction.

13. The display apparatus according to claim 12, wherein the outer multi-viewpoint lens has an asymmetric shape with respect to a center of the outer multi-viewpoint lens in the second direction.

14. The display apparatus according to claim 12, wherein an angle at which a traveling direction of light emitted from the reflective portion included in the outer multi-viewpoint lens is inclined with respect to the first direction is greater than an angle at which a traveling direction of light emitted from the reflective portion included in the central multi-viewpoint lens is inclined with respect to the first direction.

15. The display apparatus according to claim 1, wherein the first direction and the second direction are perpendicular to each other, and
wherein the multi-viewpoint lens extends in a third direction different from the first direction and the second direction.
